(19) Europäisches Patentamt
European Patent Office
Office européen des brevets

(11) **EP 4 266 175 B1**

(12) **EUROPÄISCHE PATENTSCHRIFT**

(45) Veröffentlichungstag und Bekanntmachung des Hinweises auf die Patenterteilung:
**04.09.2024** Patentblatt **2024/36**

(51) Internationale Patentklassifikation (IPC):
**G06F 11/10** (2006.01)     **G06F 11/07** (2006.01)
**G06F 11/14** (2006.01)     **G06F 11/16** (2006.01)

(21) Anmeldenummer: **22169515.8**

(22) Anmeldetag: **22.04.2022**

(52) Gemeinsame Patentklassifikation (CPC):
**G06F 11/1048; G06F 11/073; G06F 11/1008; G06F 11/1479; G06F 11/1608; G06F 11/1629**

(54) **VERFAHREN ZUM RECHNERGESTÜTZTEN BETREIBEN EINER SPEICHEREINHEIT UND AUSFÜHREN VON APPLIKATIONSPROGRAMMEN MIT SPEICHERÜBERPRÜFUNG AUF SPEICHERFEHLER**

METHOD FOR COMPUTER-ASSISTED OPERATION OF A MEMORY UNIT AND EXECUTION OF APPLICATION PROGRAMS WITH MEMORY CHECK FOR MEMORY ERRORS

PROCÉDÉ DE FONCTIONNEMENT PAR ORDINATEUR D'UNE UNITÉ DE MÉMOIRE ET D'EXÉCUTION DE PROGRAMMES D'APPLICATION À VÉRIFICATION DES ERREURS DE MÉMOIRE DE LA MÉMOIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**25.10.2023** Patentblatt **2023/43**

(73) Patentinhaber: **Siemens Mobility GmbH**
**81739 München (DE)**

(72) Erfinder:
• **Gerken, Stefan**
**38116 Braunschweig (DE)**
• **Schallenberg, Andreas**
**31224 Peine (DE)**
• **Seemann, Markus**
**38102 Braunschweig (DE)**

(74) Vertreter: **Siemens Patent Attorneys**
**Postfach 22 16 34**
**80506 München (DE)**

(56) Entgegenhaltungen:
WO-A1-2006/045785     DE-A1- 10 219 501
DE-A1- 102007 040 721     DE-A1- 102014 114 157

**Beschreibung**

Die Erfindung betrifft ein Verfahren zum rechnergestützten Betreiben einer Speichereinheit, bei dem Daten in der Speichereinheit abgelegt werden und vor dem Ablegen die Daten codiert werden, Daten aus der Speichereinheit abgerufen werden und nach dem Abrufen die Daten decodiert werden, wobei die Speichereinheit auf Fehler überwacht wird, indem eine zeitliche Abfolge von rechnergestützten Prüfläufen für die Speichereinheit durchgeführt wird. Außerdem betrifft die Erfindung ein Verfahren zum rechnergestützten Ausführen eines Applikationsprogramms, bei dem eine Speichereinheit in der vorstehend beschriebenen Weise betrieben wird und bei dem für das Ausführen benötigte Applikationsdatensätze aus der Speichereinheit abgerufen und decodiert werden. Zuletzt betrifft die Erfindung ein Computerprogrammprodukt sowie eine Bereitstellungsvorrichtung für dieses Computerprogrammprodukt, wobei das Computerprogrammprodukt mit Programmbefehlen zur Durchführung dieses Verfahrens ausgestattet ist.

Grundsätzlich müssen sicherheitsrelevante Systeme, die rechnergestützt in einer sicherheitsrelevanten Rechenumgebung ablaufen, garantieren, dass beim Speicherabruf von Daten aus einer Speichereinheit keine Fehler auftreten. Dabei dürfen korrupte Daten für die Datenverarbeitung nicht verwendet werden. Als sicherheitsrelevant wird im Rahmen dieser Erfindung eine Relevanz für die Betriebssicherheit des Systems verstanden (auch Safety genannt). Beispielsweise gelten Bahnanwendungen als sicherheitsrelevante Systeme im genannten Sinne des Begriffes.

Um sicherheitsrelevante Rechenumgebungen abzusichern, ist es bekannt, dass auf einem Rechner in mehreren Recheninstanzen zuverlässig nur die Komponenten installiert werden, welche für die Bearbeitung der betreffenden Applikation verwendet werden. Läuft die Applikation dann parallel in mehreren Recheninstanzen ab, kann durch ein Voting in an sich bekannter Weise festgestellt werden, ob Fehler bei der Berechnung auftreten, wodurch auch Speicherfehler aufgedeckt werden können.

Gemäß der WO 2014/00924382 ist ein Verfahren und ein Rechner beschrieben, welches/welcher einen Prüfalgorithmus für die Verarbeitung von Applikationen in der durch den Rechner gebildeten Rechenumgebung aufweist. Auf dem Rechner sind Applikationsprogramme installiert, die redundant ausgeführt werden, so dass der Prüfalgorithmus eine Möglichkeit hat, durch einen Vergleich der Berechnungsergebnisse Fehler aufzudecken (wie erwähnt auch Voting genannt) . Dieses Verfahren ist jedoch mit einem bedeutenden Aufwand an Hardware verbunden und lässt überdies bei bestimmten Konstellationen keine zuverlässige Fehlererkennung zu.

In der DE 10 2007 040721 ist weiterhin eine Datenverarbeitungsanordnung mit einem Speicher beschrieben, die eine Mehrzahl von Speicherelementen zum Speichern jeweils eines Datenwortes aufweist. Jedem Speicherelement der Mehrzahl von Speicherelementen wird eine Signaturinformation zugeordnet, die auf einer dem Speicherelement zugeordneten Adressinformation basiert. Einem Datenwort wird ein Codewort zugeordnet, indem das Datenwort und die Signaturinformation als Zahlenwerte dargestellt werden und das Codewort durch eine Rechenoperation aus dem Datenwort und der Signaturinformation gebildet wird.

Die Aufgabe der Erfindung besteht darin, ein Verfahren zum rechnergestützten Betreiben einer Speichereinheit sowie ein Verfahren zum rechnergestützten Ausführen eines Applikationsprogramms, bei dem eine solche Speichereinheit zum Einsatz kommt, anzugeben, mit dem sich die Zuverlässigkeit einer Speicherüberprüfung auf Speicherfehler verbessern lässt. Außerdem besteht die Aufgabe der Erfindung darin, ein Computerprogrammprodukt sowie eine Bereitstellungsvorrichtung für dieses Computerprogrammprodukt anzugeben, mit dem das vorgenannte Verfahren durchgeführt werden kann.

Diese Aufgabe wird mit dem eingangs angegebenen Anspruchsgegenstand (Verfahren zum rechnergestützten Betreiben einer Speichereinheit) erfindungsgemäß dadurch gelöst, dass zum erstmaligen Codieren der Daten

- mindestens ein Applikationsdatensatz, enthaltend Datenabschnitte mit Applikationsdaten für ein Applikationsprogramm und Prüfdatenabschnitte erzeugt oder ausgewählt wird,
- für jeden Applikationsdatensatz der Prüfdatenabschnitt mit Zähldaten (ZD), die den sich in der Durchführung befindenden Prüflauf kennzeichnen, belegt werden,
- jeder Applikationsdatensatz codiert und abgelegt wird, und dass zum Prüfen der Daten in dem sich in der Durchführung befindenden Prüflauf nach dem Abrufen und Decodieren der Applikationsdatensätze jeweils
- für einen Applikationsdatensatz ein Fehler festgestellt wird, wenn die Zähldaten (ZD) weder den sich in der Durchführung befindenden Prüflauf noch den jüngsten vollständig durchgeführten Prüflauf kennzeichnen,
- der Prüfdatenabschnitt des betreffenden Applikationsdatenabschnitts mit Zähldaten (ZD), die den sich in der Durchführung befindenden Prüflauf kennzeichnen, belegt werden, wenn kein Fehler festgestellt wurde,
- der betreffende Applikationsdatensatz wieder codiert und abgelegt wird, wenn kein Fehler festgestellt wurde.

Dadurch, dass jedem der Datenabschnitte beim erstmaligen Codieren ein Prüfdatenabschnitt (der vorher erzeugt wurde, wenn es noch keinen Prüfdatenabschnitt gab, oder ausgewählt wurde, wenn für den betreffenden Datenabschnitt schon ein Prüfdatenabschnitt zur Verfügung stand) zugeordnet wird, können in dem betreffenden Datensatz Zähldaten abgespeichert werden, die Information über den in Ausführung befindlichen Prüflauf beinhalten. Durch die anschließende Codierung des betreffenden Datensatzes werden die Zähldaten sowie auch die anderen Daten des betreffenden Datenabschnittes bis zum Decodieren vor einem Zugriff geschützt. Die Daten können im codierten Zustand nämlich nicht versehentlich (beispielsweise durch eine Fehlfunktion) oder willentlich (zum Beispiel durch einen externen Angriff) geändert werden, ohne, dass eine Änderung beim Decodieren der Daten als Fehler erkannt wird. Zumindest wird es extrem unwahrscheinlich, dass die Änderung bei Dekodierung der Datensatzes nicht als Fehler auffällt. Insofern gibt es zwar keinen Schutz vor Änderungen an sich, sondern nur vor unentdeckten Änderungen. Durch die zyklische Prüfung des Speicherinhaltes auf korrekte Kodierung (unter Anwendung der Zähldaten) werden auch sog. schlafende Fehler entdeckt. Hiermit sind Fehler gemeint, die während der Speicherung der Daten zum Beispiel durch physikalische Änderungen des Speichermediums (Bitkipper usw.) auftreten können. Die geringe Wahrscheinlichkeit, Fehler nicht zu entdecken, macht erfindungsgemäß die Einhaltung höherer Sicherheitslevel (SEL-1 ... SIL-4) möglich.

Es werden in dem Datensatz vorzugsweise alle Daten geschützt, die das Applikationsprogramm benötigt, d.h. sowohl die Daten, die das Programm an sich ausmachen, als auch die Daten, die zu verarbeitende Informationen darstellen.

Zum Beispiel ist es möglich, dass aufgrund von Speicherfehlern, d. h. Fehlern, die während der Speicherung der Daten auf einer Speichereinheit auftreten (beispielsweise sogenannte Bit-Kipper) oder aufgrund von Verarbeitungsfehlern, d. h. Fehlern, die während der Bearbeitung des Datensatzes auftreten, die Zähldaten verändert werden. Eine solche Veränderung wird dann jedoch beim Durchlaufen des nächsten Prüflaufes festgestellt, wenn die Zähldaten weder den sich in der Durchführung befindenden Prüflauf noch den jüngsten vollständig durchgeführten Prüflauf kennzeichnen. In einem solchen Fall wird ein Fehler festgestellt. Auch wenn dessen Ursache vielleicht nicht eindeutig festgestellt werden kann und eventuell unschädlich für eine Datenverarbeitung wäre, wird aus Gründen des zu erreichenden Sicherheitsniveaus nach Feststellung des Fehlers dieser beispielsweise ausgegeben und/oder es werden Maßnahmen getroffen, die eine weitere Bearbeitung der fehlerhaften Daten unterbinden.

Nur wenn kein Fehler festgestellt wird, werden die Zähldaten in dem Prüfdatenabschnitt mit den Zähldaten des in Durchführung befindlichen Prüflaufes belegt, der Datensatz codiert und wieder abgelegt. Hierdurch wird der betreffende Datensatz gleichzeitig als im betreffenden Prüflauf geprüft gekennzeichnet (wobei später noch eine Möglichkeit erläutert wird, wie Datensätze auch außerhalb eines Prüflaufes mit den aktuellen Zähldaten im Prüfdatenabschnitt belegt werden können).

Zähldaten müssen die Eigenschaft aufweisen, dass diese eine Reihe bilden, bei denen jeweils der Vorgänger und der Nachfolger jedes Elementes der Menge der Zähldaten bekannt ist. Hierbei können grundsätzlich alle mathematischen Reihen zum Einsatz kommen. Besonders bevorzugt kann die Menge der natürlichen Zahlen ausgewählt werden.

Um den Prüflauf durchzuführen, wird vorzugsweise ein Applikationsprogramm (Dienstprogramm) genutzt, welches den Prüflauf durchführt. Zu diesem Zweck greift das betreffende Applikationsprogramm, welches auch als Prüfprogramm bezeichnet werden kann, auf die Speichereinheit zu, decodiert, prüft und codiert Datensatz für Datensatz, bis ein Prüflauf vollständig durchgeführt wurde. Für den Fall, dass ein Fehler festgestellt wird, kann dieser durch das Prüfprogramm ausgegeben werden. Dabei kann das Prüfprogramm auch Funktionen enthalten, die eine Reaktion auf einen festgestellten Fehler enthalten, beispielsweise das Aussetzen eines Applikationsprogramms (Nutzprogramms) welches die fehlerhaften Datenabschnitte der Applikation (aus Applikationsdatenabschnitte genannt) verwendet und daher potenziell sicherheitsrelevante Fehler machen könnte. Hierdurch werden verschiedene Fehlerquellen erkennbar gemacht.

Die Durchführung des Prüflaufes kann beispielsweise über die Adressierung der einzelnen Datensätze gesteuert werden. Sind die Adressen aller Datensätze am Anfang des Prüflaufs bekannt, können die Datensätze sequenziell aufgerufen werden, bis der Prüflauf beendet ist (hierzu im Folgenden noch mehr).

Wird ein Prüflauf als ganzer fehlerhaft durchgeführt, dahingehend, dass dieser nicht alle Datensätze eines Prüflaufes prüft, so fällt dies spätestens beim nächsten Prüflauf auf, zumindest vorausgesetzt, dass die nicht geprüften Datensätze im folgenden Prüflauf wieder geprüft werden. Diese weisen dann nämlich noch die Zähldaten des vorletzten Prüflaufes auf, was während des folgenden Prüflaufes auffällt. Hierdurch wird ein Fehler erkannt und ausgegeben. Die Zähldaten ermöglichen daher auch ein Monitoring der ordnungsgemäßen Durchführung der Prüfläufe selbst. Damit wird eine weitere Fehlerquelle erkennbar gemacht. Daten, die als veraltet und damit potenziell fehlerhaft (weil nicht regelmäßig in einem Prüflauf überprüft) eingestuft werden, sind hinsichtlich ihrer Integrität nicht sicher genug, weswegen dies als Fehler gewertet wird.

Hiermit wird ein Sicherheitsmechanismus geschaffen, der einen Betrieb der Speichereinheit sowie das Ausführen von Applikationsprogrammen (hierbei handelt es sich um Dienstprogramme oder Nutzprogramme, hierzu im Folgenden noch mehr) im Sinne der Aufgabenstellung erhöht. Von dieser Erhöhung profitieren vorteilhaft insbesondere sicherheitsrelevante Anwendungen, beispielsweise Bahn-Anwendungen, die als Zulassungsvoraussetzung bestimmte Sicherheitsniveaus (auch Sicherheitslevel, SIL-1 ... SIL-4 oder Safety Integrity Level genannt) genügen müssen. Der Begriff "Sicherheit" ist im Rahmen dieser Erfindung im Sinne von Betriebssicherheit (Safety) zu verstehen. Insbesondere erfolgt die Codierung in erster Linie nach Gesichtspunkten der Betriebssicherheit und nicht nach Gesichtspunkten der Übertragungssicherheit (Security). Erfindungsgemäß ist daher vorzugsweise ein Codierungsverfahren vorgesehen, welches beim Codieren sowie Decodieren eine hohe Performance erreicht (mit dem Effekt kurzer Codierungs- und Decodierungszeiten) und nicht einen hohen Schwierigkeitsgrad garantiert, eine Codierung ohne Autorisierung zu entschlüsseln.

Allgemein kann mit dem erfindungsgemäßen Verfahren zum Betreiben der Speichereinheit sowie zum Ausführen von Applikationsprogrammen durch Überprüfung des Datenabschnittes, enthaltend Daten für die Applikationsprogramme, sowie des Prüfdatenabschnitts, enthaltend weitere Kriterien, die eine Überprüfung erleichtern, festgestellt werden, welche Datensätze tatsächlich oder zumindest potenziell korrupt sind und daher die Betriebssicherheit bei der Ausführung der Applikationsprogramme, insbesondere der Nutzprogramme, gefährden. Die betroffenen Datensätze werden durch Ausgabe eines Fehlers gekennzeichnet und vorzugsweise im weiteren Verlauf von einer Datenverarbeitung ausgeschlossen.

Erfindungsgemäß wird mit anderen Worten die Betriebssicherheit sozusagen an die Datensätze selbst gekoppelt. Zu diesem Zweck sind diese erfindungsgemäß mit geeigneten Prüfdatenabschnitten versehen. Dies ermöglicht es vorteilhaft, dass die Datensätze auf ein und derselben Speichereinheit abgelegt werden können, auch wenn Prozesse aus Gründen der Betriebssicherheit parallel (redundant) ablaufen. Insbesondere können dadurch zur Speicherung der Datensätze sowie zum Abarbeiten der Applikationsprogramme kommerziell erhältliche Software- und Hardwarekomponenten, sogenannte COTS-Komponenten (COTS steht für Commercial off-the-shelf) zum Einsatz kommen, ohne dass hierbei die Anforderungen an die Betriebssicherheit gefährdet werden. Derartige Komponenten können daher beispielsweise auch bei Applikationen der Bahntechnik zur Anwendung kommen und proprietäre System ablösen. Vorteilhaft sind COTS-Komponenten kostengünstig in der Anschaffung und können auch bei Bedarf einfacher ausgetauscht werden und in Cloudlösungen integriert werden.

Unter "rechnergestützt" oder "computerimplementiert" kann im Zusammenhang mit der Erfindung eine Implementierung des Verfahrens verstanden werden, bei dem mindestens ein Computer oder Prozessor mindestens einen Verfahrensschritt des Verfahrens ausführt.

Unter einer "Rechenumgebung" kann im Zusammenhang mit der Erfindung eine Infrastruktur, bestehend aus Komponenten wie Computern, Speichereinheiten, Programmen und aus mit den Programmen zu verarbeitenden Daten, verstanden werden, die zur Ausführung mindestens einer Applikation, die eine Aufgabe zu erfüllen hat, verwendet werden. Die Infrastruktur kann insbesondere auch aus einem Netzwerk der genannten Komponenten bestehen.

Unter einer "Recheninstanz" (oder kurz Instanz) kann innerhalb einer Rechenumgebung eine funktionsfähige Einheit verstanden werden, die einer Applikation zugeordnet werden kann und diese ausführen kann. Diese funktionsfähige Einheit bildet bei der Ausführung der Applikation ein physikalisch und/oder virtuell in sich geschlossene System.

Der Ausdruck "Rechner" oder "Computer" deckt alle elektronischen Geräte mit Datenverarbeitungseigenschaften ab. Computer können beispielsweise Personal Computer, Server, Handheld-Computer, Mobilfunkgeräte und andere Kommunikationsgeräte, die rechnergestützt Daten verarbeiten, Prozessoren und andere elektronische Geräte zur Datenverarbeitung sein, die vorzugsweise über Schnittstellen auch zu einem Netzwerk zusammengeschlossen sein können.

Unter einem "Prozessor" kann im Zusammenhang mit der Erfindung beispielsweise ein Wandler, ein Sensor zur Erzeugung von Messsignalen oder eine elektronische Schaltung verstanden werden. Bei einem Prozessor kann es sich insbesondere um einen Hauptprozessor (engl. Central Processing Unit, CPU), einen Mikroprozessor, einen Mikrocontroller, oder einen digitalen Signalprozessor, möglicherweise in Kombination mit einer Speichereinheit zum Speichern von Programmbefehlen und Daten handeln. Auch kann unter einem Prozessor ein virtualisierter Prozessor oder eine Soft-CPU verstanden werden.

Unter einer "Speichereinheit" kann im Zusammenhang mit der Erfindung beispielsweise ein computerlesbarer Speicher in Form eines Arbeitsspeichers (engl. Random-Access Memory, RAM) oder Datenspeichers (Festplatte oder Datenträger) verstanden werden.

Als "Schnittstellen" können hardwaretechnisch, beispielsweise kabelgebunden oder als Funkverbindung, und/oder softwaretechnisch, beispielweise als Interaktion zwischen einzelnen Programmmodulen oder Programmteilen eines oder mehrerer Computerprogramme, realisiert sein.

Als "Cloud" soll eine Umgebung für ein "Cloud-Computing" (auch Rechnerwolke oder Datenwolke bezeichnet) verstanden werden. Gemeint ist eine IT-Infrastruktur, welche über Schnittstellen eines Netzwerks wie das Internet verfügbar gemacht wird. Sie beinhaltet in der Regel Speicherplatz, Rechenleistung oder Software als Dienstleistung, ohne dass diese auf dem die Cloud nutzenden lokalen Computer installiert sein müssen. Die im Rahmen des Cloud-Computings angebotenen Dienstleistungen umfassen das gesamte Spektrum der Informationstechnik und beinhaltet unter anderem Infrastruktur, Plattformen und Software.

Als "Programmmodule" sollen einzelne Funktionseinheiten verstanden werden, die einen erfindungsgemäßen Programmablauf von Verfahrensschritten ermöglichen. Diese Funktionseinheiten können in einem einzigen Computerprogramm oder in mehreren miteinander kommunizierenden Computerprogrammen verwirklicht sein. Die hierbei realisierten Schnittstellen können softwaretechnisch innerhalb eines einzigen Prozessors umgesetzt sein oder hardwaretechnisch, wenn mehrere Prozessoren zum Einsatz kommen.

Sofern es in der nachfolgenden Beschreibung nicht anders angegeben ist, beziehen sich die Begriffe "erstellen", "feststellen", "berechnen", "generieren", "konfigurieren", "modifizieren" und dergleichen vorzugsweise auf Prozesse, die Daten erzeugen und/oder verändern und/oder die Daten in andere Daten überführen. Dabei liegen die Daten insbesondere als physikalische Größen vor, beispielsweise als elektrische Impulse oder analoge elektrische Größen. Die erforderlichen Anweisungen sind in einem Computerprogramm als Software zusammengefasst. Weiterhin beziehen sich die Begriffe "senden", "empfangen", "einlesen", "auslesen", "übertragen" und dergleichen auf das Zusammenspiel einzelner Hardwarekomponenten und/oder Softwarekomponenten über Schnittstellen.

Gemäß einer Ausgestaltung der Erfindung ist vorgesehen, dass vor dem erstmaligen Durchführen eines Prüflaufes ein Startwert für die Zähldaten festgelegt wird.

Bei dem Startwert muss es sich um ein Element der verwendeten Zahlenreihe handeln. Insbesondere bei Verwendung der natürlichen Zahlen als Zähldaten eine natürliche Zahl. Dabei ist es vorteilhaft, eine Zahl ungleich eins zu verwenden und insbesondere bei Verwendung von mehreren Speichereinheiten unterschiedliche Startwerte zu verwenden, weil dies die Wahrscheinlichkeit von zufälligen Übereinstimmungen von falschen Zähldaten unterschiedlicher Speichereinheiten zusätzlich verringert. Hierdurch wird vorteilhaft die Prozesssicherheit weiter erhöht, da die Wahrscheinlichkeit, dass unerkannte Speicherfehler oder Verarbeitungsfehler auftreten, weiter verringert wird.

Gemäß einer Ausgestaltung der Erfindung ist vorgesehen, dass die Prüfläufe jeweils zumindest die Prüfung aller zu Beginn des Prüflaufes für das laufende Verfahren zur Verfügung stehenden Applikationsdatensätze beinhalten.

Bei dieser Ausgestaltung des Verfahrens wird am Anfang des Prüflaufs festgestellt, welche Datensätze zu prüfen sind. Anschließend wird die ermittelte Anzahl der zu prüfenden Datensätze geprüft. Wurden alle zu prüfenden Datensätze geprüft, wird der Prüflauf abgeschlossen. Die Zähldaten können anschließend mit dem nachfolgenden Zählelement belegt werden. Durch Festlegung sozusagen des Prüfungsumfangs eines Prüfungslaufs und anschließende Durchführung desselben lässt sich das Verfahren des Prüfens vorteilhaft zuverlässig und mit geringem Rechenaufwand durchführen.

Alternativ wäre es auch möglich, in einem Prüflauf nur gezielt diejenigen Datensätze zu überprüfen, die während des vorhergehenden Prüflaufes verändert wurden. Dies würde allerdings eine Überwachung der Datensätze auf Nutzung oder Änderungen beinhalten, was den Ablauf des Verfahrens komplizierter machen würde. Außerdem können Speicherfehler wie Bit-Kipper auch auftreten, während nicht auf die gespeicherten Daten zugegriffen wird. Auf die Änderung von Datensätzen wird im Folgenden noch näher eingegangen.

Grundsätzlich ist es möglich, einen Prüflauf durchzuführen, wenn gerade alle zu prüfenden Datensätze nicht durch Applikationsprogramme benötigt (abgerufen und/oder verändert werden). Es ist aber auch möglich, den Prüflauf parallel zu ablaufenden Applikationsprogrammen durchzuführen, also, während die Applikationsprogramme auf die Gesamtheit der in Prüfung befindlichen Datensätze zugreifen. In diesem Fall können Datensätze, die gerade bearbeitet werden, nicht geprüft werden (hierzu im Folgenden noch mehr).

Gemäß einer Ausgestaltung der Erfindung ist vorgesehen, dass, sobald ein Prüflauf abgeschlossen wurde, die Zähldaten mit einem Zählelement belegt werden, dass dem Zählelement für die bisherige Belegung der Zähldaten folgt.

Ein Prüflauf wurde abgeschlossen, wenn alle Applikationsdatensätze, die der Prüflauf beinhaltet, geprüft wurden. Dies bedeutet, dass während des Prüflaufs ein Monitoring stattfindet, welche Applikationsdatensätze bereits geprüft wurden und welche nicht. Dies lässt sich zum Beispiel mittels der Adressen der Applikationsdatensätze bewerkstelligen, mit denen die Applikationsdatensätze identifiziert werden können.

Ist ein Prüflauf beendet, und wurden die Zähldaten, die dem Applikationsprogramm für die Prüfung zur Verfügung gestellt werden, mit dem nachfolgenden Zählelement belegt, dann kann das Applikationsprogramm im nachfolgenden Prüflauf die aktualisierten Zähldaten abrufen. Bei einer Prüfung der gespeicherten Datensätze ist es dann möglich, zu prüfen, ob die Datensätze jeweils die Zähldaten des vorhergehenden Prüflaufes beinhalten, denn das Applikationsprogramm "kennt" durch das vorherige Heraufsetzen der Zähldaten sozusagen das Zählelement des aktuellen Prüflaufs. Da die Zähldaten bei jedem geprüften Datensatz (zumindest, wenn kein Fehler festgestellt wurde), auf das aktuelle Zählelement gesetzt werden, können die Prüfläufe nach diesem Verfahren beliebig oft wiederholt werden.

Die genannte Aufgabe wird alternativ mit dem eingangs angegebenen Anspruchsgegenstand (Verfahren zum rechnergestützten Ausführen eines Applikationsprogramms) erfindungsgemäß auch dadurch gelöst, dass zum rechnergestützten Ausführen eines Applikationsprogramms, bei dem eine Speichereinheit wie vorstehend erläutert betrieben wird und bei dem für das Ausführen benötigte Applikationsdatensätze aus der Speichereinheit abgerufen und decodiert werden,

- nach dem Decodieren der Applikationsdatensätze das Applikationsprogramm ausgeführt wird,
- zumindest Applikationsdatensätze, die durch das Ausführen des Applikationsprogramms geänderte oder erzeugte Datenabschnitte beinhalten, codiert und in der Speichereinheit abgelegt werden.

Das Ausführen des Applikationsprogramms kann vorzugsweise schrittweise erfolgen. Dies bedeutet, dass auch die für die Ausführung des Applikationsprogramms erforderlichen Applikationsdatensätze jeweils zumindest nur für den bevorstehenden Schritt des Applikationsprogramms aus der Speichereinheit abgerufen und die codiert werden müssen. Natürlich wird bei der Abarbeitung des Applikationsprogramms nach und nach die schrittweise die Gesamtheit der für die Abarbeitung des Applikationsprogramms erforderlichen Applikationsdatensätze abgerufen und decodiert.

Dadurch, dass die Speichereinheit, wie vorstehend nach dem Verfahren zum rechnergestützten Betreiben der Speichereinheit beschrieben, betrieben wird, werden mit anderen Worten Applikationsdatensätze, die durch das Ausführen des Applikationsprogramms (Nutzprogramms) geänderte oder erzeugte Datenabschnitte beinhalten, beim Codieren auch mit den Zähldaten belegt, die den aktuellen, sich in Durchführung befindlichen Prüflauf kennzeichnen.

Dies hat verschiedene Vorteile. Werden neue Datensätze erstellt oder Datensätze geändert (d. h. Daten in einem bestehenden Datensatz, insbesondere die Datenabschnitte mit Applikationsdaten werden geändert), werden diese mit Zähldaten abgelegt, die geeignet sind, die entsprechenden Datensätze zumindest im nächsten Prüflauf mitzuprüfen. Sollten die abgelegten Datensätze fehlerfrei sein, sind diese nämlich im nächsten Prüflauf auch mit den geeigneten Zähldaten ausgestattet, damit diese als fehlerfrei erkannt werden können.

Diese Ausgestaltung der Erfindung hat auch den Vorteil, dass Datensätze, die bei einem parallel zur Datenbearbeitung durch Applikationsprogramme ablaufenden Prüflauf gerade zur Prüfung nicht zur Verfügung stehen, durch den Prüflauf ausgelassen werden können, da diese bei Abarbeitung durch ein Applikationsprogramm, insbesondere durch ein Nutzprogramm, mit aktuellen Zahldaten belegt werden, die eine Prüfung im nachfolgenden Prüflauf ermöglichen, auch wenn eine Prüfung (z. B. durch ein Prüfprogramm) im aktuellen Prüflauf aufgrund der parallelen Bearbeitung durch das Applikationsprogramm (Nutzprogramm oder Dienstprogramm) ausgelassen wird. Dies vereinfacht insbesondere den Ablauf des Prüflaufes beträchtlich, da der Prüflauf bei der Abarbeitung der Prüfroutine in Bearbeitung befindliche Datensätze einfach auslassen kann und eine Prüfung nicht zu einem späteren Zeitpunkt des aktuellen Prüflaufes nachgeholt werden muss. Vom Sicherheitsgesichtspunkt kann dies vertreten werden, da die Integrität der Daten unter Berücksichtigung der Zähldaten auch durch das Applikationsprogramm (Nutzprogramm) durchgeführt werden kann (oder in absehbarer Zeit im nächsten Prüflauf) und somit der betreffende Datensatz aktuell gehalten wird.

Gemäß einer Ausgestaltung der Erfindung ist vorgesehen, dass beim Prüfen der Daten nach dem Decodieren der Applikationsdatensätze und vor dem Ausführen des Applikationsprogramms jeweils

- für einen Applikationsdatensatz ein Fehler festgestellt wird, wenn die Zähldaten, weder den sich in der Durchführung befindenden Prüflauf noch den jüngsten vollständig durchgeführten Prüflauf kennzeichnen,
- das Applikationsprogramm ausgeführt wird, wenn kein Fehler festgestellt wurde.

Bei dieser Ausgestaltung der Erfindung werden die Vorteile, die durch eine regelmäßige Prüfung der Daten in der Speichereinheit mittels Prüfläufen erreicht werden, zusätzlich jeweils bei der Bearbeitung der Daten durch ein Applikationsprogramm (Nutzprogramm) erreicht. Mit anderen Worten wird jedes Mal, wenn Daten aus der Speichereinheit zur Bearbeitung abgerufen werden, geprüft, ob in der Zwischenzeit ein Speicherfehler aufgetreten ist. Hierdurch wird eine zusätzliche Sicherheit erreicht, da auch Speicherfehler erkannt werden können, welche in Datensätzen zwischen dem letzten erfolgreichen Prüflauf und dem Aufruf des Datensatzes durch ein Applikationsprogramm (insbesondere Nutzprogramm) zufällig aufgetreten sind.

Gemäß einer Ausgestaltung der Erfindung ist vorgesehen, dass beim rechnergestützten Betreiben der Speichereinheit zum erstmaligen Codieren der Daten zusätzlich

- mindestens eine Gruppe von Applikationsdatensätzen, enthaltend Datenabschnitte mit identischen Applikationsdaten für ein Applikationsprogramm und Prüfdatenabschnitte mit jeweils unterschiedlichen Diversitätskenndaten aus einem Vorrat möglicher Diversitätskenndaten erzeugt oder ausgewählt wird,
- jeder Applikationsdatensatz codiert und abgelegt wird,

  und das Abrufen der Daten erfolgt, indem die Applikationsdatensätze abgerufen und decodiert werden, sowie das Ablegen der Daten erfolgt, indem die Applikationsdatensätze codiert und abgelegt werden, und/oder

  dass beim rechnergestützten Ausführen das Applikationsprogramm mehrfach in redundanten Recheninstanzen ausgeführt wird, wobei zum Ausführen benötigter Applikationsdatensätze jeder Applikationsdatensatz einer codierten Gruppe von Applikationsdatensätzen aus der Speichereinheit abgerufen und decodiert wird, wobei

- zum Prüfen der Daten nach dem Decodieren der Applikationsdatensätze jeweils für einen Applikationsdatensatz ein Fehler festgestellt wird, wenn die Diversitätskenndaten in dem Applikationsdatensatz von allen möglichen Diversitätskenndaten dieser Recheninstanz aus dem Vorrat d. h. aus dem für diese Recheninstanz vorgesehenen Vorrat, abweichen,
- das Applikationsprogramm mit den Datenabschnitten jedes Applikationsdatensatzes der betreffenden Gruppe ausgeführt wird, wenn kein Fehler festgestellt wurde,
und/oder

- zumindest Applikationsdatensätze, die durch das Ausführen des Applikationsprogramms geänderte oder erzeugte Datenabschnitte beinhalten, nach in der oben genannten Weise codiert und in der Speichereinheit abgelegt werden.

Wie nachfolgend beschrieben wird, handelt es sich bei dieser Ausgestaltung der Erfindung um einen zusätzlichen Sicherheitsmechanismus, der einen Betrieb der Speichereinheit sowie das Ausführen von Applikationsprogrammen im Sinne der Aufgabenstellung zusätzlich weiter erhöht. Von dieser Erhöhung profitieren vorteilhaft insbesondere sicherheitsrelevante Anwendungen, beispielsweise Bahn-Anwendungen, wie bereits erläutert. Dabei muss nur einer der im Rahmen dieser Erfindung beschriebenen Fehler auftreten, um insgesamt die Ausgabe eines Fehlers zu bewirken. Unabhängig davon, durch welche der erfindungsgemäßen Maßnahmen der Fehler erkannt wird, wird somit die Sicherheit bei der Durchführung der Applikationsprogramme (Nutzprogramme) erhöht. Wie bereits erwähnt, ist der Begriff Sicherheit im Sinne von Betriebssicherheit (Safety) zu verstehen.

Die Bildung von Gruppen von Applikationsdatensätzen, die jeweils in Datenabschnitte mit identischen Applikationsdaten enthalten, hat den Vorteil, dass Rechenoperationen, also die Abarbeitung von Applikationsprogrammen, die die jeweils identischen Applikationsdaten nutzen, redundant durchgeführt werden können. Sollte in einem der Applikationsdatensätze ein Fehler identifiziert werden, so kann der betreffende Applikationsdatensatz von einer Bearbeitung ausgeschlossen werden, ohne dass dadurch der Verfahrensablauf sofort unterbrochen werden muss. Denn es stehen ja weitere Applikationsdatensätze für die Durchführung des Verfahrens, sprich die Abarbeitung des betreffenden Applikationsprogramms, zur Verfügung.

Die Diversitätskenndaten machen die Applikationsdatensätze mit jeweils identischen Applikationsdaten voneinander unterscheidbar und ermöglichen eine genaue Zuordnung beispielsweise zu einer für die betreffenden Applikationsdaten vorgesehenen Recheninstanz. Hierdurch kann auch geprüft werden, ob bei der Zuordnung von Applikationsdatensätzen zu bestimmten Recheninstanzen ein Fehler (als Zuordnungsfehler bezeichnet) unterlaufen ist. Auch ein solcher identifizierter Fehler kann geeignete Reaktionen im Verfahrensablauf auslösen. Zum Beispiel kann die falsche Zuordnung von Applikationsdatensätzen dazu führen, dass die betreffenden Recheninstanzen von der Durchführung des Verfahrens ausgeschlossen werden. Auch in diesem Fall können die verbleibenden Recheninstanzen das Verfahren weiterbetreiben, weswegen es nicht sofort zu einer Unterbrechung des Verfahrens kommt.

Werden für ein Applikationsprogramm (und dies ist die Regel) mehrere Applikationsdatensätze benötigt, so kann insbesondere jede Gruppe von Applikationsdatensätzen wieder dieselben Diversitätskenndaten bekommen. Diese werden aus einem Vorrat von Diversitätskenndaten ausgewählt, auf diese Weise ist durch die Diversitätskenndaten die Zuordnung von Applikationsdatensätzen zu einer bestimmten Recheninstanz mit einer bestimmten Diversität (mit anderen Worten einer Recheninstanz, der Diversitätskenndaten einer bestimmten Art aus dem Vorrat zugeordnet werden) . Dies erhöht die Betriebssicherheit bereits bedeutend und lässt sich aufgrund des begrenzten Vorrats an Diversitätskenndaten mit geringem Rechenaufwand umsetzen.

Wenn im Zusammenhang dieser Anmeldung allgemein von Daten die Rede ist, können diese einen beliebigen Inhalt haben. Demgegenüber werden unter Applikationsdaten, Diversitätskenndaten, Redundanzdaten, Zähldaten usw. bestimmte, d. h. zweckgebundene Daten verstanden. Darüber hinaus wird unterschieden zwischen

- variablen Daten: diese Daten werden laufzeitabhängig belegt oder verändert (insbesondere Applikationsdaten)
- statischen Daten: Programmdaten (insbesondere Applikationsprogramme beschreibende Applikationsdaten).

Der Datenabschnitt, enthaltend Applikationsdaten (kurz Applikationsdatenabschnitt genannt), kann ausgeführt werden (statische Daten als Instruktionen für den Ablauf des Applikationsprogramms) oder verarbeitet werden (zu verarbeitende variable Daten für das Applikationsprogramm). Ein Prüfdatenabschnitt, der vorzugsweise die Diversitätskenndaten und/oder Redundanzdaten und/oder Zähldaten enthält, dient vorzugsweise zur Abarbeitung durch Dienstprogramme, die zur Überprüfung der Integrität der Daten ablaufen (hierzu im Folgenden noch mehr).

Das codierte Ablegen der Applikationsdatensätze erhöht vorteilhaft die Wahrscheinlichkeit, Datenfehler bei der Verarbeitung (Verarbeitungsfehler) oder bei der Speicherung (Speicherfehler) zu identifizieren. Bereits ein einziger Bit-Kipper, beispielsweise während der Speicherung der Daten, würde bei der Decodierung zu einem anderen Ergebnis führen, sodass sich der codierte Applikationsdatensatz von dem zu codierenden Applikationsdatensatz deutlich unterscheidet. Wird ein solcher Fehler aufgedeckt, werden die bereits genannten Maßnahmen durchgeführt, damit das Verfahren die erforderliche Betriebssicherheit gewährleistet.

Die Verwendung der Diversitätskenndaten zur Identifizierung von Fehlern bei der Verarbeitung der Applikationsdatensätze durch ein Applikationsprogramm wurde obenstehend bereits näher erläutert. Zum Zwecke der Verarbeitung der Applikationsdatensätze werden diese decodiert und, bevor diese wieder in der Speichereinheit abgelegt werden, wieder codiert. Außerdem ist es möglich, dass Applikationsdatensätze durch das Ausführen des Applikationsprogramms geändert werden oder Applikationsdatensätze mit neu erzeugte Datenabschnitten gebildet werden. Diese werden dann nach dem oben genannten Speicherverfahren codiert und in der Speichereinheit abgelegt.

Bei der Prüfung der Diversitätskenndaten wird zumindest geprüft, ob die erkannten Diversitätskenndaten eines Applikationsdatensatzes von allen möglichen (d. h. für die betreffende Recheninstanz möglichen) Diversitätskenndaten des Vorrats abweichen. Dann wird ein Fehler festgestellt, entsprechen diese den erwarteten Diversitätskenndaten, so wird davon ausgegangen, dass kein Fehler vorliegt. Vorzugsweise wird für eine Recheninstanz auch nur eine Art von Diversitätskenndaten des Vorrats zugelassen. Allerdings ist es auch möglich, die Recheninstanzen in unterschiedlichen Bereichen zwecks besserer Auslastung der Recheninstanzen für jeweils andere Diversitätskenndaten zu reservieren (hierzu im Folgenden noch mehr).

Bei dem Prüfen der Daten kann zum Beispiel geprüft werden, ob die Diversitätskenndaten in dem Applikationsdatensatz von allen möglichen Diversitätskenndaten aus dem Vorrat abweichen, wenn es grundsätzlich möglich ist, dass alle Diversitätskenndaten aus dem Vorrat für eine bestimmte Recheninstanz genutzt werden können. Es ist aber auch möglich, dass für eine bestimmte Recheninstanz bestimmte Diversitätskenndaten aus dem Vorrat reserviert sind. Dann wird nur geprüft, ob die Diversitätskenndaten von diesen reservierten Diversitätskenndaten der Recheninstanz abweichen. Dabei steigt vorteilhaft die Wahrscheinlichkeit, durch Feststellen falscher Diversitätskenndaten einen Fehler aufzudecken.

Gemäß einer Ausgestaltung der Erfindung ist vorgesehen, dass die unterschiedlichen Diversitätskenndaten des Vorrats unterschiedliche Codierungskonstanten und Decodierungskonstanten beinhalten.

Die Codierungskonstanten kommen in einem Codierungsalgorithmus und die Decodierungskonstanten in einem Decodierungsalgorithmus zum Einsatz. Derartige Codierungsalgorithmen und Decodierungsalgorithmen sind an sich bekannt. Mittels der Konstanten lässt sich vorteilhaft eine Codierung und Decodierung mit einer hohen Performance umsetzen. Hierbei geht es lediglich um die Erlangung der Betriebssicherheit (Safety), nicht um die Erlangung einer ausreichenden Sicherheit gegen feindliche Angriffe (Security) die nur mit einem bedeutend höheren Rechenaufwand und damit verbundenen Verlust an Rechenperformance möglich wäre.

Werden die Codierungskonstanten und Decodierungskonstanten gleichzeitig als Diversitätskenndaten verwendet, hat dies den Vorteil, dass die Diversität der Applikationsdatensätze in der Codierung enthalten ist. D. h., dass für die Codierung und Decodierung ein Paar von Konstanten zum Einsatz kommt, die gleichzeitig die Diversität des betreffenden Applikationsdatensatzes definieren. Mit den Konstanten werden damit gleich zwei Funktionalitäten gleichzeitig erfüllt, was Rechenaufwand spart und daher die Performance des Verfahrens erhöht.

Gemäß einer Ausgestaltung der Erfindung ist vorgesehen, dass die Diversitätskenndaten einen Anpassungsoperator zur Anpassung des durch das Decodieren erzeugten Datenabschnitts an den Datenabschnitt vor dem Decodieren beinhalten.

Der Anpassungsoperator ist erforderlich, wenn der Informationsgehalt (z. B. Bitbreite) des codierten und anschließend decodierten Applikationsdatensatzes größer ist als derjenige des codierten Applikationsdatensatzes. Die überflüssigen Informationen dürfen dann nach der Decodierung des Applikationsdatensatzes durch die durchzuführende Applikation nicht berücksichtigt werden und müssen durch den Anpassungsoperator sozusagen abgeschnitten werden. Allgemein ergibt sich für einen Codierungs- und Dekodierungsalgorithmus damit die Funktionsgleichung

$$((AD\ opA\ C\_enc)\ opB\ C\_dec)\ opC\ Y == AD$$

mit

AD       Applikationsdatensatz
opA     Codierungsoperator
C_enc   Codierungskonstante
opB     Decodierungsoperator
C_des   Decodierungskonstante
opC     Anpassungsoperator
Y        gewünschter Informationsgehalt (Bitbreite)

Gemäß einer Ausgestaltung der Erfindung ist vorgesehen, dass der Codierungsoperator eine Anweisung ist, mit der eine Multiplikation durchgeführt wird.

Gemäß einer weiteren Ausgestaltung der Erfindung ist vorgesehen, dass der Decodierungsoperator (und insbesondere auch der Codierungsoperator) eine Anweisung ist, mit der als Decodierungsoperation (und insbesondere aus als Codierungsoperation) eine Multiplikation durchgeführt wird und der Anpassungsoperator dazu geeignet ist nach dem Decodieren den Datenabschnitt auf seine ursprüngliche Länge (Bitbreite) zu begrenzen.

Werden als Decodierungsoperator (und insbesondere auch als Codierungsoperator) eine Multiplikation ausgewählt, so handelt es sich hierbei um eine Operation, die vorteilhaft mit einer hohen Performance in einem Rechner umgesetzt werden kann. Insbesondere wenn die Decodierungskonstante (und insbesondere auch die Codierungskonstante) größer 1 und ganzzahlig sind, lässt sich die Operation besonders einfach rechentechnisch umsetzen. Allerdings wird durch das zweimalige Multiplizieren die Länge des codierten und anschließend des dekodieren Datenabschnittes größer. Nach dem Decodieren muss daher der eigentliche Informationsgehalt des Datenabschnittes von dem gesamten Ergebnis des Decodierens sozusagen abgeschnitten werden.

Hierzu eignet sich vorzugsweise eine Modulo-Operation mod (auch als Längenbeschränkungsoperation zu bezeichnen), die vorteilhaft bei binären Ausdrücken die überschüssigen Bits bis zu einer gewünschten Bitbreite Y abschneiden ohne den Inhalt der Bits des verbliebenen Rests zu ändern. Um die überschüssige Information (redundante Information) im codierten Zustand zu speichern (denn nur unter Zuhilfenahme dieser redundanten Information gelingt die Dekodierung) muss für diese Daten (Bits) zusätzlicher Speicherplatz im Applikationsdatensatz vorgesehen sein. Um die Sicherheit des Verfahrens noch zu erhöhen, können die Daten im zusätzlichen Speicherplatz als Redundanzdaten zusätzlich auf Fehler überprüft werden (hierzu im Folgenden noch mehr).

Unter Berücksichtigung der Multiplikation als Codierungs- und Dekodierungsoperation und der Modulo-Operation als Anpassungsoperator ergibt sich für die vorstehende Funktionsgleichung für die Codierung und Decodierung folgender Ausdruck:

$$(AD \cdot C\_enc \cdot C\_dec) \bmod Y == AD$$

Mit

| | |
|---|---|
| AD | Applikationsdatensatz |
| C_enc | Codierungskonstante > 1 |
| C_dec | Decodierungskonstante > 1 |
| mod Y | Modulo-Operaton |
| Y | gewünschten Bitbreite |

Bei der Codierungskonstante sowie der Decodierungskonstante handelt es sich um ein Zahlenpaar, welches insbesondere auch die Diversität des betreffenden Applikationsdatensatzes kennzeichnet. Dieses Zahlenpaar wird so ausgewählt, dass bei einer Multiplikation des Applikationsdatensatzes mit der Kodierungskonstante und der anschließenden Multiplikation des codierten Applikationsdatensatzes mit der Dekodierungskonstante die Bits der gewünschten Bitbreite Y der Applikationsdaten wieder dieselben Werte pro Bit aufweisen. In dem Vorrat für Diversitätskenndaten sind für jede Diversität je eine Codierungskonstante und eine Decodierungskonstante verfügbar, die jeweils ein Zahlenpaar mit den genannten Eigenschaften bilden. Es hat sich durch Versuche gezeigt, dass ein Codierungs- und Dekodierungsalgorithmus, der die letztgenannte Funktionsgleichung nutzt, mit einer vergleichsweise hohen Performance hinsichtlich der Rechengeschwindigkeit durchgeführt werden kann.

Gemäß einer Ausgestaltung der Erfindung ist vorgesehen, dass vor dem Codieren der Prüfdatenabschnitt derart erstellt wird, dass dieser zusätzlich redundanten Speicherplatz mit vorgegebenen Redundanzdaten aufweist.

Wie nachfolgend beschrieben wird, handelt es sich bei dieser Ausgestaltung der Erfindung um einen zusätzlichen Sicherheitsmechanismus, der einen Betrieb der Speichereinheit sowie das Ausführen von Applikationsprogrammen im Sinne der Aufgabenstellung zusätzlich weiter erhöht. Von dieser Erhöhung profitieren vorteilhaft insbesondere sicherheitsrelevante Anwendungen, wie bereits erläutert.

Der Sicherheitsgewinn liegt darin, dass die vorgegebenen Redundanzdaten in dem Verfahren, weil vorgegeben, auch bekannt sind. Redundant bedeutet bei den Redundanzdaten, dass diese nicht zur Speicherung der Applikationsdaten erforderlich sind. Die Redundanzdaten werden jedoch für das Codieren benötigt, weil das Datenvolumen (Bitbreite) sich dabei vergrößert. Dabei werden die Redundanzdaten durch neue Daten belegt, die normalerweise von den vorgegebenen Redundanzdaten abweichen. Diese neuen Daten sind für ein anschließendes Decodieren erforderlich.

Wird eine entsprechender Codierungs- bzw. Decodierungsalgotithmus werden die Redundanzdaten jedoch nach dem Decodieren wieder mit den ursprünglich vorgegebenen Daten befüllt. Dies bedeutet, dass ein Fehler festgestellt wird, wenn diese Bedingung nicht erfüllt ist.

Vorzugsweise können die vorgegebenen Daten nur Nullen oder nur Einsen enthalten. Die Befüllung mit vorgegebenen Daten lässt sich auf diese Weise besonders einfach mit geringem Rechenaufwand durchführen.

Gemäß einer Ausgestaltung der Erfindung ist vorgesehen, dass die Applikationsdatenabschnitte aus Datenwörtern bestehen.

Ein Datenwort ist eine bestimmte Datenmenge, die ein Computer in der arithmetisch-logischen Einheit des Prozessors in einem Schritt verarbeiten kann. Ist eine maximale Datenmenge gemeint, so wird deren Größe Wortbreite, Verarbeitungsbreite oder Busbreite genannt. Ein Datenwort kann vorzugsweise eine Wortbreite von 32, 64 oder 128 Bit haben. Wenn die Applikationsdatenabschnitte aus Datenwörtern bestehen, beschleunigt dies vorteilhaft die Abarbeitung der einzelnen Verfahrensschritte, wodurch das erfindungsgemäße Verfahren mit einer optimalen Performance durchgeführt werden kann.

Gemäß einer Ausgestaltung der Erfindung ist vorgesehen, dass das Verfahren unter gleichzeitiger Nutzung von mindestens zwei Prozessoren oder Prozessorkernen durchgeführt wird.

Die Prozessoren können, wir bereits erwähnt, physisch (auch mit Prozessorkernen) oder virtuell (z. B. emuliert) ausgeführt sein. Mehrere Prozessoren oder Prozessorkerne können vorteilhaft insbesondere dazu verwendet werden, Rechenprozesse redundant, d. h. parallel und insbesondere auch gleichzeitig, durchzuführen, um eine zusätzliche Sicherheit hinsichtlich eines Auftretens von Fehlern bei der Bearbeitung der Applikationsdatenätze zu erzielen. Das Auftreten von Fehlern kann beispielsweise, wie im Folgenden noch näher erläutert wird, durch ein Voting überprüft werden.

Gemäß einer Ausgestaltung der Erfindung ist vorgesehen, dass die mindestens zwei Prozessoren oder Prozessorkerne gemeinsam auf ein und dieselbe Speichereinheit zugreifen.

Mit einem Zugriff auf ein und dieselbe Speichereinheit ist gemeint, dass die mindestens zwei Prozessoren / Prozessorkerne eine gemeinsam Speichereinheit nutzen, wobei die Speichereinheit keine physikalische Trennung von Speicherbereichen für den einen Prozessor oder den anderen Prozessor vorsieht. Mit anderen Worten kann jeder Prozessor grundsätzlich auf den gesamten durch die Speichereinheit zur Verfügung gestellten Speicherbereich zugreifen. Dies schließt natürlich nicht aus, dass bestimmte Speicherbereiche beispielsweise durch die Definition von Speicheradressen für den einen oder den anderen Prozessor reserviert werden. Jedoch kann diese Reservierung ohne hardwaremäßige Eingriffe geändert bzw. aufgehoben werden, sodass potenziell der gesamte Speicherbereich jedem der Prozessoren zur Verfügung steht.

Die Verwendung von gemeinsamen Speichereinheiten für mehrere Prozessoren erleichtert vorteilhaft die Verwendung von COTS-Komponenten. Außerdem ist die Anschaffung einer gemeinsamen Speichereinheit kostengünstiger, als wenn für jeden Prozessor eine eigene Speichereinheit vorgesehen wird. Hierdurch lassen sich insbesondere kostengünstige Lösungen realisieren.

Gemäß einer Ausgestaltung der Erfindung ist vorgesehen, dass

- mit mehrfach gespeicherten identischen Datenabschnitten und/oder mit mehrfach identisch geänderten Datenabschnitten ein Voting durchgeführt wird,
- wenn aufgrund des Votings ein Fehler identifiziert wird, Applikationsdatensätze, die für die Fehleridentifizierung ursächliche Datenabschnitte enthalten, von einer weiteren Bearbeitung ausgeschlossen werden.

Mehrfach gespeicherte identische Datenabschnitte und/oder mehrfach identisch geänderte Datenabschnitte entstehen, wenn Applikationsdatensätze redundant gespeichert und/oder verarbeitet werden. Die redundanten Daten (d. h. die betreffenden Applikationsdatenabschnitte) müssen identisch sein, weswegen auftretende Unterschiede durch ein Voting als Fehler identifiziert und ausgegeben werden können.

Das Durchführen eines Votings zur Identifikation von Datenfehlern ist an sich bekannt. Beispielsweise ist es möglich, unabhängige Applikationsdatensätze in mehreren, vorzugsweise drei parallelen Prozessabläufen zu berechnen und diese anschließend im Rahmen eines Votings zu vergleichen. Die Ergebnisse werden nur dann als vertrauenswürdig eingestuft, wenn zumindest die Mehrheit der verglichenen Ergebnisse übereinstimmt. Die parallele Abarbeitung einer Applikation durch die Rechenumgebung kann dabei insbesondere durch drei parallel bearbeitete Applikationsdatensätze in der Rechenumgebung durchgeführt werden. Hierdurch kann vorteilhaft sichergestellt werden, dass die Bearbeitung eines Datensatzes jeweils rückkopplungsfrei bezüglich der anderen Bearbeitungen durchgeführt werden kann. Damit kann vorteilhaft die Wahrscheinlichkeit so weit wie möglich verringert werden, dass das Auftreten von Fehlern in der Bearbeitung eines Applikationsdatensatzes sich auch auf die Bearbeitung anderer Datensätze auswirkt.

Bei Feststellung eines Datenfehlers in einem Prüflauf oder beim Ausführen des Applikationsprogramms bzw. eines Verarbeitungsfehlers beim Voting kann eine weitere Verarbeitung der Daten unterbunden oder zumindest ausgesetzt werden oder nur für Applikationen unterbunden oder zumindest ausgesetzt werden, die einen vorgegebenen Sicherheitslevel erreichen oder überschreiten. Dies hat den Vorteil, dass die Rechenkapazität der betroffenen Hostrechner für nicht sicherheitsrelevante Applikationen weiter zur Verfügung stehen. Hiermit ist gemeint, dass die Applikationen durchgeführt werden können, wenn auftretende Fehler (beispielsweise ein Programmabsturz) keine sicherheitsrelevanten Risiken bergen (sicherheitsrelevante Risiken sind bei Bahnapplikationen beispielsweise Zugkollisionen oder andere Unfälle).

Vorteilhaft kann vorgesehen werden, dass das erste und das zweite der Applikationsprogramme gestoppt wird, wenn die zu vergleichenden Datenabschnitte nicht übereinstimmen oder die Zähldaten in den zu diesen Datenabschnitten gehörigen Prüfdatenabschnitten weder den sich in der Durchführung befindenden Prüflauf noch den jüngsten vollständig durchgeführten Prüflauf kennzeichnen.

Durch das Stoppen des Programmablaufes wird vorteilhaft wirksam verhindert, dass die fehlerhafte Bearbeitung der Applikation weiter fortgeführt wird. Im Anschluss daran kann das betreffende Applikationsprogramm (inkl. Teilprogrammen, Programmkomplexen) auch wieder gestartet werden, wenn der Fehler behoben wurde. Insbesondere, wenn die Applikationsprogramme redundant ausgeführt werden, um ein anschließendes Voting der erzeugten variablen Daten durchführen zu können, kann der Betrieb beispielsweise einer Bahnanwendung weiterlaufen, während einzelne

Applikationsprogramme bzw. Hostrechner neu gestartet werden.

Gemäß einer Ausgestaltung der Erfindung ist vorgesehen, dass

- Applikationsdatensätze, die für Fehler ursächliche Datenabschnitte enthalten, unter Nutzung der fehlerfreien Datenabschnitte der entsprechenden Applikationsdatensätze aktualisiert werden,
- die aktualisierten Applikationsdatensätze wieder in die weitere Bearbeitung einbezogen werden.

Für eine Aktualisierung werden somit die entsprechenden Applikationsdatensätze verwendet, die betreffende fehlerfreie Datenabschnitte enthalten. Dies bedeutet, dass in den Applikationsdatensätzen die Datenabschnitte mit identischen Applikationsdaten ausgewählt werden, mit anderen Worten Applikationsdatensätze, die derselben Gruppe von Applikationsdatensätzen angehören. Diese unterscheiden sich, wie bereits erläutert, nämlich nur durch die Prüfdatenabschnitte, jedoch nicht durch die die Applikationsdaten repräsentierenden Datenabschnitte, d. h. Applikationsdatenabschnitte, sodass diese sozusagen zur Reparatur des erkannten Fehlers genutzt werden können - vorausgesetzt, die fehlerfreien Datenabschnitte konnten durch das Voting identifiziert werden.

Die Aktualisierung von fehlerbehafteten Datenabschnitten ermöglicht den dauerhaften Betrieb der Rechenumgebung. Andernfalls würden durch Feststellung von Fehlern immer mehr Applikationsdatensätze gesperrt werden, sodass das Verfahren auf Dauer nicht mehr lauffähig wäre. Auch ein Voting könnte mangels Redundanz bei der Datenerzeugung irgendwann nicht mehr durchgeführt werden.

Die Redundanz der Daten ermöglicht neben einem Voting aber auch den Betrieb der Rechenumgebung, d. h. die Bearbeitung der Applikationsdatensätze, während Fehler in einzelnen Applikationsdatensätzen festgestellt und korrigiert werden. Letztere werden nämlich nur so lange von einer Bearbeitung ausgeschlossen, bis diese nach dem obenstehenden Verfahren repariert wurden. Während des Ausschlusses korrupter Applikationsdatensätze existieren allerdings weitere redundante Applikationsdatensätze mit integren Daten, mit denen das Verfahren, ohne dass es bei der Applikation zu Verzögerungen kommt, weiter durchgeführt werden kann. Die reparierten Applikationsdatensätze können dann später, z. B. in einer Betriebspause aktiviert werden.

Des Weiteren wird ein Computerprogrammprodukt mit Programmbefehlen zur Durchführung des genannten erfindungsgemäßen Verfahrens und/oder dessen Ausführungsbeispielen beansprucht, wobei mittels des Computerprogrammprodukts jeweils das erfindungsgemäße Verfahren und/oder dessen Ausführungsbeispiele durchführbar sind.

Darüber hinaus wird eine Bereitstellungsvorrichtung zum Speichern und/oder Bereitstellen des Computerprogrammprodukts beansprucht. Die Bereitstellungsvorrichtung ist beispielsweise ein Speichereinheit, die das Computerprogrammprodukt speichert und/oder bereitstellt. Alternativ und/oder zusätzlich ist die Bereitstellungsvorrichtung beispielsweise ein Netzwerkdienst, ein Computersystem, ein Serversystem, insbesondere ein verteiltes, beispielsweise cloudbasiertes Computersystem und/oder virtuelles Rechnersystem, welches das Computerprogrammprodukt vorzugsweise in Form eines Datenstroms speichert und/oder bereitstellt.

Die Bereitstellung erfolgt in Form eines Programmdatenblocks als Datei, insbesondere als Downloaddatei, oder als Datenstrom, insbesondere als Downloaddatenstrom, des Computerprogrammprodukts. Diese Bereitstellung kann beispielsweise aber auch als partieller Download erfolgen, der aus mehreren Teilen besteht. Ein solches Computerprogrammprodukt wird beispielsweise unter Verwendung der Bereitstellungsvorrichtung in ein System eingelesen, sodass das erfindungsgemäße Verfahren auf einem Computer zur Ausführung gebracht wird.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Komponenten auch durch mit den vorstehend beschriebenen Merkmalen der Erfindung kombinierbar.

Es zeigen:

Figur 1 eine Bahnanwendung mit einer Rechenumgebung mit ihren Wirkzusammenhängen schematisch, wobei ein Ausführungsbeispiel des erfindungsbemäßen Verfahrens mit der Rechenumgebung ausgeführt werden kann,

Figur 2 (bestehend aus den Teilfiguren 2A und 2B, verteilt auf zwei Seiten) ein Ausführungsbeispiel des erfindungsgemäßen Verfahrens anhand einer Rechenumgebung in der Bahnanwendung gemäß Figur 1 mit zwei Hostrechnern als Blockschaltbild, wobei die einzelnen Funktionseinheiten Programmmodule enthalten, die Applikationsprogramme ergeben und jeweils in einem oder mehreren Prozessoren ablaufen können und die Schnittstellen demgemäß softwaretechnisch oder hardwaretechnisch ausgeführt sein Können.

Figur 3 und 4 Ausführungsbeispiele des erfindungsgemäßen Verfahrens als Flussdiagramm, wobei die einzelnen Verfahrensschritte einzeln oder in Gruppen durch Programmmodule verwirklicht sein können und wobei die Funktionseinheiten und Schnittstellen gemäß Figur 2 beispielhaft angedeutet sind.

Figur 5 ein möglicher Verfahrensablauf für das Verfahren zum rechnergestützten Betreiben einer Speichereinheit sowie zum rechnergestützten Ausführen eines Applikationsprogramms.

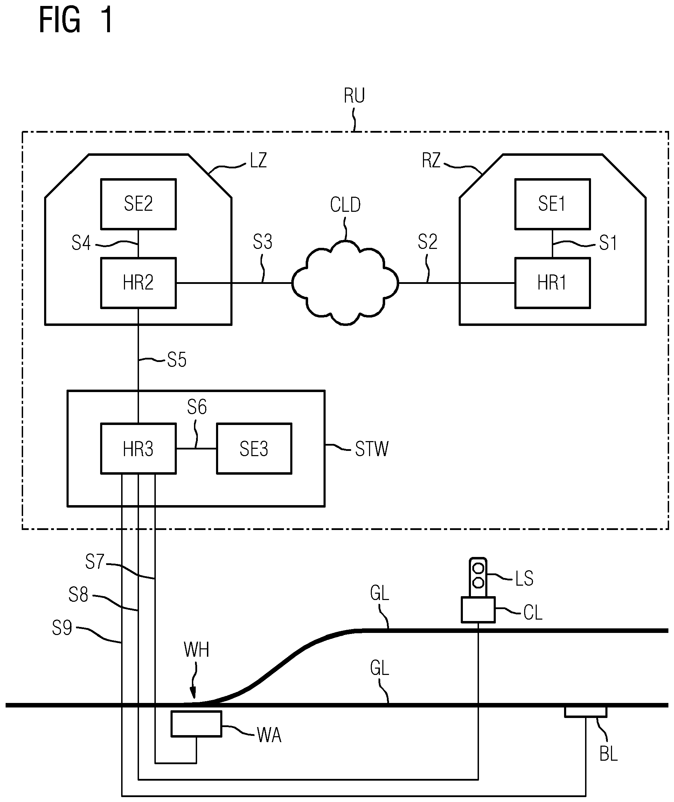

In Figur 1 ist schematisch eine Bahnanwendung dargestellt, welche durch eine Rechnerumgebung RU gesteuert wird. Die Bahnanwendung weist Gleise GL auf, an denen verschiedene Komponenten der Stellwerkstechnik exemplarisch dargestellt sind. Hierbei handelt es sich um einen Weichenantrieb WA, der eine Weiche WH stellen kann. Weiterhin ist eine Balise BL in einem der Gleise verbaut, mit deren Hilfe Informationen mit die Balise überfahrenden Zügen ausgetauscht werden können. Zuletzt ist ein Lichtsignal LS dargestellt, welches durch einen Controller CL gesteuert wird. Die Rechnerumgebung RU kann verschiedene Hostrechner HR1, HR2, HR3 aufweisen, auf die Applikationen zum Steuern der Bahnanwendung in Form von Applikationsprogrammen (hierzu im Folgenden noch mehr) verteilt sind. Der erste Hostrechner HR1 wird durch ein Rechenzentrum RZ zur Verfügung gestellt und ist über eine erste Schnittstelle S1 mit einer ersten Speichereinheit SE1 verbunden. Das Rechenzentrum RZ kann beispielsweise durch einen Dienstleister des Bahnbetreibers oder durch den Bahnbetreiber selbst betrieben werden. Über eine zweite Schnittstelle S2 ist der erste Hostrechner HR1 mit einer Cloud CLD verbunden, sodass dieser örtlich nicht an die Bahnanwendung gebunden ist.

Eine Leitzentrale LZ des Bahnbetreibers beherbergt den zweiten Hostrechner HR2, der über eine dritte Schnittstelle S3 ebenfalls mit der Cloud CLD verbunden ist. Außerdem ist der zweite Hostrechner HR2 über eine vierte Schnittstelle S4 mit einer zweiten Speichereinheit SE2 verbunden.

Die Rechnerumgebung RU weist außerdem exemplarisch ein Stellwerk STW auf, welches den dritten Hostrechner HR3 beherbergt, der über eine sechste Schnittstelle S6 mit einer dritten Speichereinheit SE3 verbunden ist. Außerdem weist der dritte Hostrechner HR3 eine fünfte Schnittstelle S5 zum zweiten Hostrechner HR2 auf. In nicht dargestellter Weise könnte der Hostrechner HR3 auch mit der Cloud CLD verbunden sein. Der dritte Hostrechner HR3 weist außerdem eine siebte Schnittstelle S7 zum Weichenantrieb WA, eine achte Schnittstelle S8 zu dem Controller CL und eine neunte Schnittstelle S9 zu der Balise BL auf.

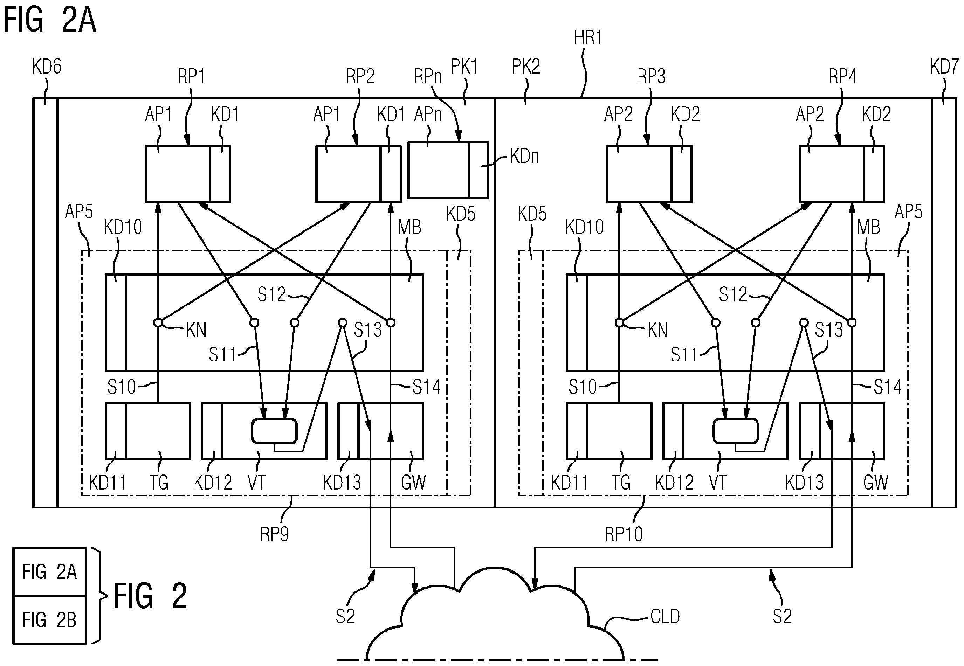

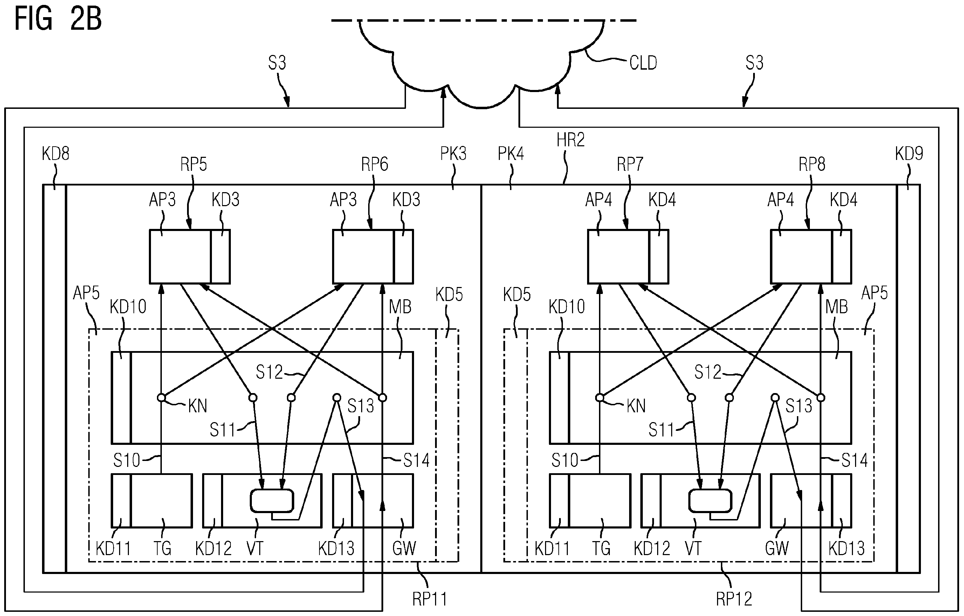

Alle Schnittstellen S1 ... S9 gemäß Figur 1 sind grundsätzlich kabelgebunden oder auch durch eine kabellose Übertragungstechnik, beispielsweise Funk, realisierbar. Die Anordnung der Hostrechner HR1 ... HR3 ist lediglich exemplarisch und kann bei komplexeren Bahnanlagen beliebig erweitert werden. Eine Rechenumgebung wird dadurch definiert, dass die Beteiligten Hostrechner HR1 ... HR3 untereinander kommunizieren können und dadurch die Applikationen unter Berücksichtigung verfügbarer Rechenkapazitäten verteilt auf den Hostrechner HR1 ... HR3 abgearbeitet werden können. Hierzu werden nicht näher dargestellter Recheninstanzen gebildet, die im Folgenden noch näher beschrieben werden (vergleiche Figur 2 wo die Recheninstanzen RP1 ... RPn dargestellt sind) .

Figur 2 stellt die Konfiguration des ersten Hostrechners HR1 und des zweiten Hostrechners HR2 gemäß Figur 1 exemplarisch dar. Die Einbindung weiterer Hostrechner kann analog erfolgen. Die Hostrechner sind so organisiert, dass zur Bewältigung bestimmte Aufgabenkomplexe in Form von Programmkomplexen PK1, PK2, PK3, PK4 auf den Hostrechnern organisiert werden, welche aus einzelnen Applikationsprogrammen AP1 ... AP5 bestehen.

Programmkomplexe fassen allgemein eine Anzahl von Applikationsprogrammen zusammen, deren gemeinsame Abarbeitung mit Blick auf die Gesamtheit von Applikationen zusammengefasst werden kann. Insbesondere kann vorgesehen werden, dass alle in einem Datensatz enthaltenen Applikationsprogramme zu einem Programmkomplex zusammengefasst werden. Dabei wird dem Umstand Rechnung getragen, dass der Datensatz hinsichtlich der zur Anwendung kommenden Daten eine Zusammenfassung von Datenabschnitten bewirkt, während parallel hierzu ein Programmkomplex die entsprechenden Applikationsprogramme, denen die Datenabschnitte zugeordnet sind, zusammenfasst.

Als Konfigurationsdaten KD1 ... KD13 sollen Daten verstanden werden, welche Applikationsprogramme für die individuellen Anforderungen des vorliegenden Anwendungsfalls konfigurieren. Die Konfiguration definiert das Zusammenspiel verschiedener Applikationsprogramme untereinander sowie die Funktion der Applikationsprogramme auf den Hardwarekomponenten, auf denen diese installiert sind. Außerdem enthält die Konfiguration Anpassungen auf den vorliegenden Anwendungsfall, für welchen das betreffende Applikationsprogramm gedacht ist (beispielsweise Parameter, die sich in verschiedenen Anwendungsfällen unterscheiden können).

Anhand des fünften Applikationsprogramms AP5 ist außerdem gezeigt, dass dieses durch einzelne Teilprogramme realisiert werden kann. Die Teilprogramme des fünften Applikationsprogramms AP5 sind ein Gateway GW, ein Voter VT, ein Taktgeber TG und ein Message Broker MB (hierzu im Folgenden noch mehr) . Dies ist aber nur als Beispiel zu verstehen. Alternativ könnte zum Bespiel der Taktgeber in einer anderen (nicht sicheren) Applikation laufen, während die restlichen Teilprogramme wie beschrieben in dem einen (sicheren) Applikationsprogramm AP5 laufen.

Als Teilprogramme im Sinne der Erfindung sind allgemein kleinere Einheiten wie Programmmodule zu verstehen, deren Gesamtheit das Applikationsprogramm ergeben. Somit ist es vorteilhaft möglich, Applikationsprogramme modular aufzubauen, d. h. beispielsweise Programmmodule vorzusehen, die in mehreren Applikationsprogrammen zum Einsatz kommen. Dabei können die Teilprogramme abhängig von ihrem Einsatz mit unterschiedlichen Konfigurationsdaten konfiguriert werden. Teilprogramme machen es somit möglich, Applikationsprogramme einfacher erstellen zu können und damit die Rechenumgebung einfacher an einen Anwendungsfall anpassen zu können.

Im Zusammenhang mit der Erstellung von Programmkomplexen, Applikationsprogrammen und Teilprogrammen soll angemerkt werden, dass jeweils den Programmkomplexen, den Applikationsprogrammen sowie den Teilprogrammen jeweils Konfigurationsdaten zugeordnet werden können. Hierbei kann es zu einer mehrfachen Abspeicherung von bestimmten Daten desselben Inhalts kommen, wobei diese jeweils Datenabschnitte ergeben, die wiederum eindeutig einem Programmkomplex, Applikationsprogrammen oder Teilprogrammen zugeordnet werden können. Wichtig ist hierbei die Möglichkeit einer eindeutigen Zuordnung, um zur Verwirklichung von Prüffunktionen eindeutig adressierbare Datenabschnitte zur Verfügung zu haben.

Das fünfte Applikationsprogramm AP5 ist in allen Programmkomplexen PK1 ... PK4 gleich organisiert. Über den Gateway GW können Nachrichten mit der Cloud CLD ausgetauscht werden. Daher bildet der Gateway GW die Schnittstellen S2 und S3 gemäß Figur 1 aus. Über den Message Broker MB werden die Nachrichten innerhalb des Programmkomplexes PK1 ... PK4 verteilt, vorzugsweise nach dem Publish-Subscribe-Verfahren. Der Gateway GW nutzt beispielsweise eine Schnittstelle S14, um empfangene Nachrichten redundanten Recheninstanzen RP1 ... RPn über den Message Broker MB zur Verfügung zu stellen. Diese werden dann durch die redundanten Recheninstanzen RP1 ... RPn abgerufen. Dies ist durch Knoten KN angedeutet, welche in der Schnittstelle S14 (und ebenfalls in den weiteren, im Folgenden noch beschriebenen Schnittstellen S10 ... S13) angedeutet sind.

In Figur 2 sind der Übersichtlichkeit halber die Programmkomplexe PK1 ... PK4 jeweils vollständig in einem Hostrechner HR1 ... HR2 realisiert. In der Realität können Programmkomplexe mit ihren Applikationsprogrammen AP1 ... AP5 und deren Teilprogrammen auch auf mehreren Hostrechnern verteilt ablaufen (nicht dargestellt) . Dies ermöglicht es vorteilhaft, Kapazitäten von Hostrechnern zu nutzen, wenn diese für die Konfiguration eines ganzen Programmkomplexes nicht ausreichend Kapazität zur Verfügung stellen, indem die Kapazität von mehreren Hostrechnern für den betreffenden Programmkomplexe gemeinsam genutzt wird.

Die Programmkomplexe können beispielsweise für einen bestimmten Aufgabenkomplex vorgesehen werden. Beispielsweise kann ein Programmkomplex zur Ansteuerung einer bestimmten Bahnkomponente (Signal, Stellwerk, Weiche, Achszähler usw.) Verwendung finden. Für die Ansteuerung dieser Bahnkomponente sind im Allgemeinen mehrere Applikationsprogramme erforderlich. Insbesondere wird auch das bereits vorstehend erläuterte Applikationsprogramm AP5 benötigt, um eine sichere Ausführung der Applikation sowie Kommunikation mit anderen Hostrechnern zu gewährleisten. Dieses ist als Dienstprogramm zu bezeichnen, welches einer Sicherung der Funktion des Hostrechners dient und damit eine den Hostrechner betreffende Applikation ausführt (im Gegensatz zu den Nutzdaten für Bahnkomponenten verarbeitenden Applikationsprogrammen AP1 ... AP4 die somit als Nutzprogramme bezeichnet werden). Das Applikationsprogramm AP5 läuft ebenfalls in mindestens einer Recheninstanz RP9 ... RP12 pro Hostrechner, jedoch vorzugsweise nicht redundant.

Als eine Vielzahl redundanter Recheninstanzen im Sinne der Erfindung wird eine Softwareimplementierung auf den Hostrechnern HR1 ... HR3 verstanden, die eine parallele, sprich gleichzeitige Abarbeitung von Applikationsprogrammen AP1 ... AP4, vorzugsweise innerhalb des jeweiligen Programmkomplexes PK1 ... PK4 erlauben. In Figur 2 dargestellt sind Programmkomplexe mit je zwei redundanten Recheninstanzen, vorzugsweise werden jedoch drei redundante Recheninstanzen verwendet, es sind aber auch mehr redundante Recheninstanzen RP1 ... RPn, wie exemplarisch für den ersten Programmkomplex dargestellt, denkbar. Im Folgenden wird das Verfahren zur Abarbeitung der Applikationsprogramme anhand des ersten Programmkomplexes PK1 für die erste redundante Recheninstanz RP1, die zweite redundante Recheninstanz RP2 ... und die n-te redundante Recheninstanz zur Abarbeitung des ersten Applikationsprogramms AP1 erläutert. Für die Programmkomplexe PK2 ... PK4 läuft die Abarbeitung aber entsprechend ab, sodass diese nicht gesondert erläutert werden muss.

In der ersten redundante Recheninstanz RP1, ... und der n-ten redundante Recheninstanz RPn wird das erste Applikationsprogramm AP1 redundant, also zeitgleich parallel, abgearbeitet. Hierbei handelt es sich um ein Applikationsprogramm, welches eine Aufgabe für die Bahnanwendung gemäß Figur 1 übernimmt. Von der ersten redundanten Recheninstanz RP1, bis zur der n-ten redundanten Recheninstanz RP2 stehen überdies erste Konfigurationsdaten KD1 zur Verfügung, welche zur Ausführung des ersten Applikationsprogramms AP1 zur Abarbeitung der individuellen Aufgabe der Bahnanwendung erforderlich sind. Beispielsweise kann das erste Applikationsprogramm AP1 allgemein zur Ansteuerung von Lichtsignalen dienen, wobei die ersten Konfigurationsdaten KD1 die Anwendung des ersten Applikationsprogramms AP1 auf das Lichtsignal LS gemäß Figur 1 gewährleisten. Hierbei muss beispielsweise eine Kommunikation mit dem Controller CL gemäß Figur 1 sichergestellt werden.

Konfigurationsdaten KD1 ... KD13 stehen auch für alle anderen Programmkomplexe PK1 ... PK4, Applikationsprogramme AP1 ... AP4 sowie Teilprogramme MB, TG, VT, GW zur Verfügung. Entsprechend enthalten die Konfigurationsdaten KD1 ... KD13 die jeweils für die Programmkomplexe, Applikationsprogramme und Teilprogramme erforderlichen Daten, damit diese die ihnen zugewiesenen Aufgaben im betreffenden Anwendungsfall übernehmen können. Dabei sind die Konfigurationsdaten jeweils unveränderlich und können daher in einem Datenabschnitt mit bekanntem Anfang und bekanntem Ende abgespeichert werden. Ebenso werden alle Programmkomplexe PK1 ... PK4, Applikationsprogramme AP1 ... AP4 sowie Teilprogramme TG, VT, GW, MB als Datenabschnitte mit bekanntem Anfang und bekanntem Ende abgespeichert. Hierfür stehen beispielsweise die erste Speichereinheit SE1, die zweite Speichereinheit SE2 sowie die dritte Speichereinheit SE3 gemäß Figur 1 zur Verfügung. Daten, die in einer der genannten Speichereinheiten abgelegt werden oder über einen gewissen Zeitraum in einer der genannten Speichereinheiten gespeichert bleiben, werden regelmäßigen Prüfläufen unterzogen, durch die Speicherfehler in den abgespeicherten Daten erkannt werden können (hierzu im Folgenden noch mehr). Als Speicherfehler werden Fehler verstanden, die in den Daten beim Ablegen oder beim Abrufen der Daten auftreten oder entstehen, während die Daten in der Speichereinheit gespeichert werden.

Daten, die sich während der Abarbeitung von Programmen verändern, werden zwischen den beteiligten Partnern als Nachrichten ausgetauscht. Hierfür steht, wie bereits erwähnt, der Message Broker MB zur Verfügung. Außerdem kommunizieren die einzelnen Hostrechner HR1, HR2 über die externen Schnittstellen S2, S3 beispielsweise mittels einer Cloud CLD untereinander, damit Daten auch zwischen verschiedenen Programmkomplexen PK1 ... PK4 verschiedener Hostrechner ausgetauscht werden können. Nach Änderung der Daten werden diese wieder in der ersten Speichereinheit SE1, der zweiten Speichereinheit SE2 oder der dritten Speichereinheit SE3 abgelegt. Auch bei der Verarbeitung der Daten können Fehler in den Daten auftreten, die im Rahmen dieser Erfindung genauer als Verarbeitungsfehler bezeichnet werden.

Die Abläufe in der Bahnanwendung gemäß Figur 1 sind sicherheitsrelevant für die Betriebssicherheit der Bahnanwendung. Dies ist der Grund, warum das erste Applikationsprogramm AP1 in der ersten redundanten Recheninstanz RP1 bis zur der n-ten redundanten Recheninstanz RPn zeitlich parallel, d. h. redundant, abgearbeitet wird. Die erste redundante Recheninstanz RP1 und die zweite redundante Recheninstanz RP2 (usw.) senden das Ergebnis bei der Abarbeitung der Applikation an den Message Broker MB, und zwar die erste redundante Recheninstanz RP1 über die elfte Schnittstelle S11 und die zweite redundante Recheninstanz über die Schnittstelle S12 (usw.). Diese Ergebnisse werden über die genannten Schnittstellen von dem Voter VT abgerufen, der ein Voting durchführt. Nur, wenn die Mehrheit der Ergebnisse übereinstimmt (d.h. bei zwei redundanten Recheninstanzen beide Ergebnisse, bei drei redundanten Recheninstanzen mindestens zwei Ergebnisse, bei vier redundanten Recheninstanzen mindestens drei Ergebnisse, ... bei n redundanten Recheninstanzen mindestens n/2+1 bei geraden und n/2+0,5 bei ungeraden n), wird das Ergebnis über die dreizehnte Schnittstelle S13 dem Message Broker zur Verfügung gestellt und kann von dem Gateway GW über die dreizehnte Schnittstelle S13 zur Übertragung an andere Einheiten über die zweite Schnittstelle S2 abgerufen werden.

Damit die Berechnungsergebnisse für das Voting durch den Voter VT gleichzeitig zur Verfügung stehen, werden die Prozesse in der ersten redundanten Recheninstanz RP1 und in der zweiten redundanten Recheninstanz RP2 (usw.) über den Taktgeber TG getaktet. Dieser stellt Taktsignale über die zehnte Schnittstelle S10 zur Verfügung, die ebenfalls über den Message Broker MB von der ersten redundanten Recheninstanz RP1 und der zweiten redundanten Recheninstanz RP2 abgerufen werden können.

Die geschilderte Art der Abarbeitung von Aufgaben durch das erste Applikationsprogramm AP1 und das zweite Applikationsprogramm AP2 wird durch das fünfte Applikationsprogramm AP5 sichergestellt. Bei dem fünften Applikationsprogramm AP5 handelt es sich also um ein internes Applikationsprogramm, welches die Funktionsweise der Hostrechner HR1 ... HR3 unterstützt. Dies macht deutlich, dass Applikationsprogramme nicht nur für die Applikation der Bahnanwendung gemäß Figur 1 (Nutzprogramme), sondern auch für die Abarbeitung von Applikationen in den Hostrechnern HR1 ... HR3 (Dienstprogramme) zur Verfügung gestellt werden müssen.

Die Zusammenfassung von Applikationsprogrammen zu Programmkomplexen sowie die Unterteilung von Applikationsprogrammen in Teilprogramme erleichtert hierbei die Zusammenstellung von Applikationsprogrammen sowie die Prüfung der Abarbeitung der Aufgaben auf Fehlerfreiheit. Zu diesem Zweck werden Daten zu Datenabschnitten zusammengefasst, die jeweils als solche eindeutig identifiziert und adressiert werden können (durch Definition eines Anfangs des Datenabschnitts sowie eines Endes des Datenabschnitts). In Datenabschnitten werden, wie bereits erwähnt, Teilprogramme, Applikationsprogramme, Programmekomplexe sowie die jeweilig zugehörigen Konfigurationsdaten definiert (wobei diese gewöhnlich aus einer Vielzahl von Datenabschnitten bestehen). Hierbei werden die erforderlichen Daten vorzugsweise unter Einsatz der Diversitätskenndaten mehrfach abgespeichert, sodass die Datenabschnitte und Konfigurationsdateien jeweils eindeutig zugeordnet werden können. Mit anderen Worten kommt es in diesem Fall nicht vor, dass unterschiedliche Applikationsprogramme, wenn diese identische Konfigurationsdaten verwenden, auf denselben Speicherort für diese Daten zugreifen, sondern immer auf den jeweils ihnen zugeordneten Datenabschnitt, in dem die Daten verfügbar sind.

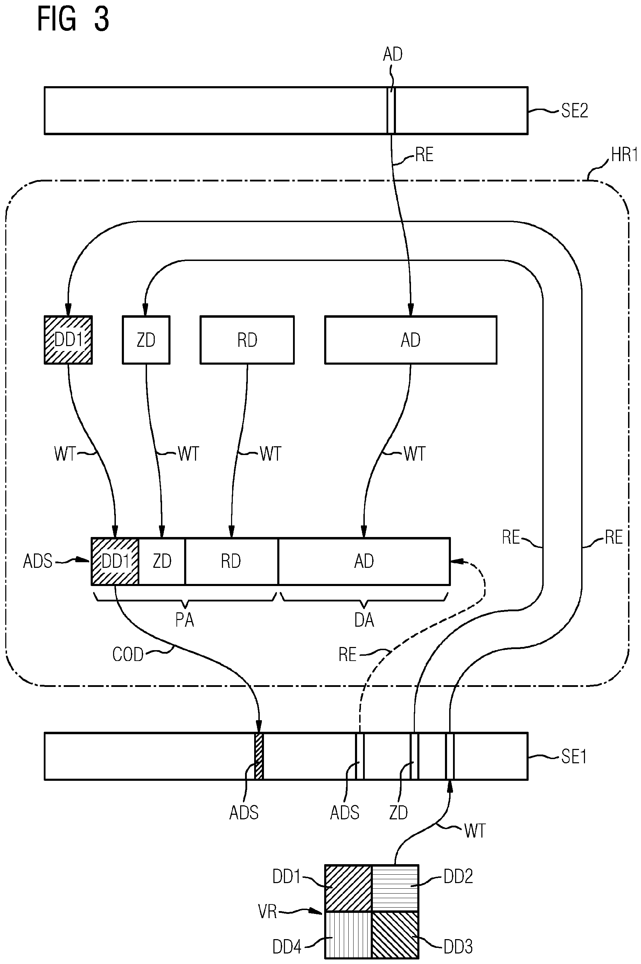

In Figur 3 ist der Verfahrensschritt eines erstmaligen Codierens von Daten gemäß der Erfindung schematisch dargestellt. Dargestellt ist dies für eine Rechenumgebung, beispielhaft bestehend aus dem ersten Hostrechner HR1, der ersten Speichereinheit SE1 sowie der zweiten Speichereinheiten SE2. Im Prinzip kann durch den ersten Hostrechner HR1 auf Daten zugegriffen werden, die in der ersten Speichereinheit SE1 und in der zweiten Speichereinheit SE2 abgespeichert sind. Dabei kann ein Lesen RE sowie ein Schreiben WT erfolgen, was durch entsprechende Pfeile angedeutet ist.

In den Speichereinheiten SE1, SE2 können beispielsweise Applikationen AP für das Durchführen von Applikationsprogrammen gespeichert sein. Weiterhin ist es möglich, Zähldaten ZD sowie ein Vorrat VR von Diversitätskenndaten DD1 ... DD4 zu speichern. Um die Applikationsdaten AD für Applikationen im Sinne der Erfindung zu nutzen, d. h. ein Verfahren zum rechnergestützten Ausführen eines Applikationsprogramms in der erfindungsgemäßen Weise durchzuführen, müssen die Applikationsdaten AD in Form von Applikationsdatensätzen ADS abgespeichert werden, die mittels des Verfahrens gemäß Figur 3 erstellt und durch ein Codieren COD codiert abgelegt werden.

In Figur 3 ist lediglich exemplarisch dargestellt, wie die Applikationsdaten AD, die Zähldaten ZD sowie die Diversitätskenndaten DD1 ... DD4 einzelne Speicherbereiche der ersten Speichereinheit SE1 und der zweiten Speichereinheit SE2 belegen. Im Prinzip ist beliebig, wo die entsprechenden Daten abgelegt sind, diese werden durch eine geeignete Adressierung aufgefunden und es gibt keine Beschränkungen, welcher Applikationsdatensatz ADS wo in den Speichereinheiten SE1, SE2 abgespeichert wird.

Weiterhin ist die Diversität der Diversitätskenndaten DD1 ... DD4 durch Schraffuren angedeutet, was deutlich machen soll, dass Applikationsdatensätze ADS durch die Diversitätskenndaten aus dem Vorrat VR gekennzeichnet werden können. Zur Verfügung stehen, wie am Vorrat VR gezeigt, eine Längsschraffur, eine Querschraffur und zwei Schrägschraffuren, welche im Winkel von 90° zueinander stehen. Der in Figur 3 im Einzelnen dargestellte Applikationsdatensatz ADS weist beispielsweise die Schraffur auf, die auf die Diversitätskenndaten DD1 hinweist.

Wie der vergrößert dargestellte Applikationsdatensatz ADS zeigt, besteht dieser aus einem Datenabschnitt DA für die Applikationsdaten AD sowie einem Prüfdatenabschnitt PA, der die ersten Diversitätskenndaten DD1, ein Zählelement in den Zähldaten ZD sowie Redundanzdaten RD aufweist. Die ersten Diversitätskenndaten DD1, die Zähldaten ZD, die Redundanzdaten RD, die mit einem Startwert befüllt sind, sowie die Applikationsdaten AD werden im Hostrechner HR1 beispielsweise in einen Arbeitsspeicher geschrieben und hierbei zu dem Applikationsdatensatz ADS zusammengefasst. Anschließend wird der Applikationsdatensatz ADS codiert und in die erste Speichereinheit SE1 geschrieben, wobei die Diversität aufgrund der ersten Diversitätskenndaten DD1 auch in der Speichereinheit SE1 durch die genannte Schraffur angedeutet ist. Hier steht der Applikationsdatensatz ADS für eine weitere Bearbeitung zur Verfügung.

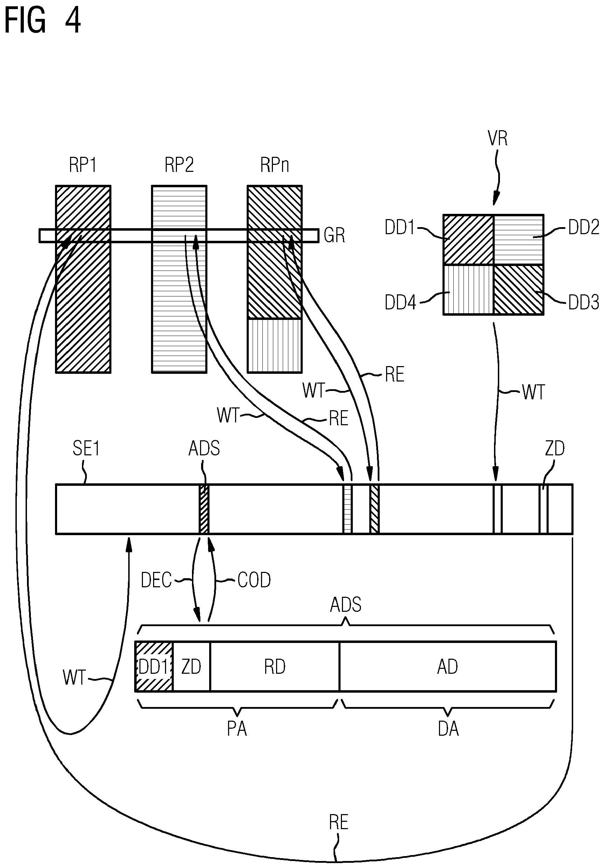

In Figur 4 ist die Verwendung des Applikationsdatensatzes gemäß Figur 3 und weitere Applikationsdatensätze mit den zweiten Diversitätskenndaten DD2 und den dritten Diversitätskenndaten DD3 schematisch dargestellt. Die drei dargestellten Applikationsdatensätze ADS sollen identische Applikationsdaten enthalten. Der Prüfdatenabschnitt PA ist in jedem Fall mit den jeweils unterschiedlichen Diversitätskenndaten DD1, DD2, DD3 belegt. Auch die Zähldaten ZD sowie die Redundanzdaten RD können voneinander abweichen.

Die Applikationsdatensätze ADS werden nun in drei Recheninstanzen RP1, RP2, RPn ausgeführt (n ist im erläuterten Bleispiel gleich 3, könnte jedoch auch einen anderen Wert haben). Zu diesem Zweck werden die Applikationsdatensätze ADS jeweils in die Recheninstanz eingelesen (RE). Dabei ist den Recheninstanzen RP1, RP2, RPn jeweils eine bestimmte Diversität zugeordnet, was durch eine Schraffur entsprechend dargestellt ist. Diese Schraffur entspricht jeweils denjenigen der Diversitätskenndaten DD1 ... DD3 des Vorrats VR.

Zu erkennen ist auch, dass eine Recheninstanz RPn auch Daten zweier Diversitäten, im vorliegenden Fall die mit den Diversitätskenndaten DD3 und den Diversitätskenndaten DD4 gekennzeichneten Applikationsdatensätze ADS verarbeiten kann. Hierdurch kann eine optimale Ausnutzung der durch die Recheninstanz RPN zur Verfügung stehenden Rechenkapazität erreicht werden.

Die Recheninstanzen RP1 ... RPn lesen jeweils die Applikationsdatensätze ADS der richtigen Diversität aus. Dies wird erreicht durch Dienstprogramme, die im Hintergrund laufen, sodass die Recheninstanzen RP1 ... RPn automatisch mit den richtigen Applikationsdatensätzen ADS versorgt werden. Dies ist für den Applikationsdatensatz ADS gemäß Figur 3 mit den Diversitätskenndaten DD1 näher dargestellt und soll genauer erläutert werden.

Wird dieser Applikationsdatensatz ADS abgerufen, wird dieser zunächst decodiert (DEC), um anschließend gelesen zu werden (RE) . Durch die Decodierung können die ersten Diversitätskenndaten DD1, die aktuellen Zähldaten ZD sowie die Redundanzdaten RD zusammen mit den Applikationsdaten AD ausgelesen werden und Dienstprogramme angewendet werden, welche eventuell aufgetretene Speicherfehler erkennen. Es kann geprüft werden, ob die Diversitätskenndaten DD1 dem Vorrat VR entstammen und/oder mit der Diversität der ersten Recheninstanz RP1 übereinstimmen. Anhand der Zähldaten ZD kann der ordnungsmäßige Verlauf von Prüfläufen überprüft werden, da diese den im Ablauf befindlichen Prüflauf oder den vorher erfolgten Prüflauf kennzeichnen müssen. Nur, wenn die Prüfung ergibt, dass die Daten keine Speicherfehler aufweisen, werden diese für ein Lesen RE freigegeben und von der ersten Recheninstanz RP1 verarbeitet.

Die erste Recheninstanz RP1 schreibt nach Bearbeitung des Applikationsdatensatzes ADS diesen zurück in die erste Speichereinheit SE1. Auch hier kann eine Überprüfung des Prüfdatenabschnitts, der ersten Diversitätskenndaten DD1, der Zähldaten ZD sowie der Redundanzdaten RD durchgeführt werden, um eventuelle Verarbeitungsfehler bei der Verarbeitung des Applikationsdatensatzes ADS zu identifizieren. Außerdem werden die Zähldaten ZD mit demjenigen Zählelement gleichgesetzt, welches den aktuell ablaufenden Prüflauf kennzeichnen. Anschließend wird der Applikationsdatensatz ADS codiert (COD) und in die erste Speichereinheit SE1 geschrieben (WT).

Dieses Verfahren wird, wenn auch nicht im Einzelnen dargestellt, ebenfalls für die weiteren Applikationsdatensätze in den Recheninstanzen RP2, RPn durchgeführt. Nach erfolgreicher Bearbeitung der Applikationsdatensätze ADS kann für die Applikationsdaten AD zusätzlich ein Voting durchgeführt werden, um festzustellen, dass die Applikationsdatensätze AD auch nach dem Bearbeiten durch die Recheninstanzen RP1 ... RPn identisch geändert wurden. Ist das nicht der Fall, weist dies auf einen Verarbeitungsfehler hin. Bei drei Recheninstanzen RP1 ... RPn kann überdies ein Mehrheitsvoting durchgeführt werden, sodass die Applikationsdaten, die mehrheitlich identisch sind, für eine weitere Verarbeitung herangezogen werden, während die Applikationsdaten, die sich von diesen unterscheiden, für eine Weiterverarbeitung gesperrt werden.

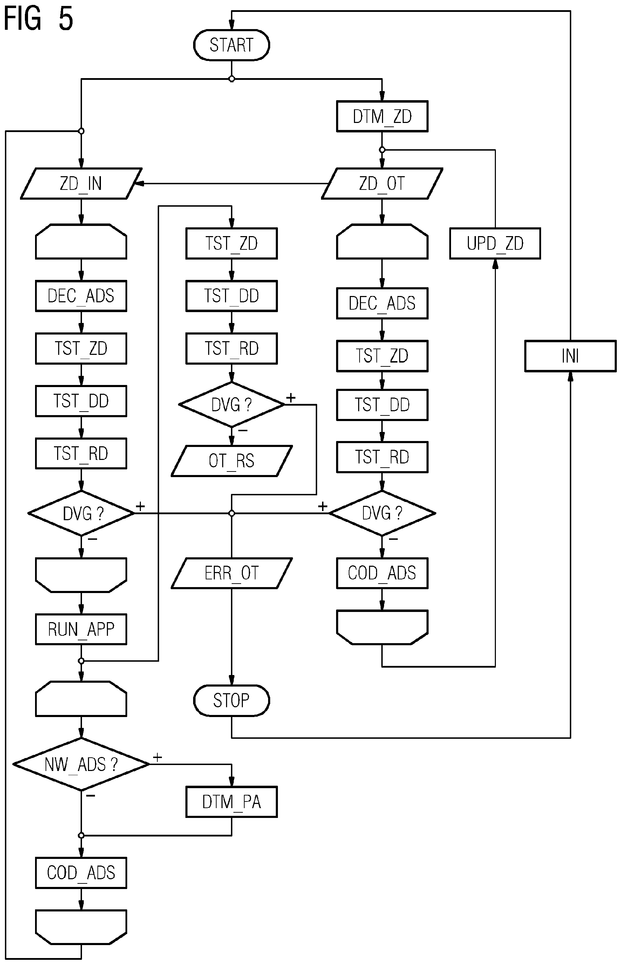

Anhang Figur 5 soll ein möglicher Verfahrensablauf für das Verfahren zum rechnergestützten Betreiben einer Speichereinheit sowie zum rechnergestützten Ausführen eines Applikationsprogramms erläutert werden. Vor einem Start des Verfahrens wird ein Initialisierungsschritt INI durchgeführt, wobei dieser den ordnungsgemäßen Speicherzugriff auf eine nicht dargestellte Speichereinheit erlaubt. Nach dem Start des Verfahrens werden hier das Verfahren zum Durchführen von Prüfläufen der Speichereinheit auf der rechten Seite sowie das Ausführen von Applikationsprogrammen auf der linken Seite dargestellt. Diese Teilbereiche können einzeln nacheinander bzw. vorzugsweise parallel durchgeführt werden und sind deshalb nebeneinander dargestellt.

Zunächst soll das Verfahren zum Durchführen des Prüflaufs erläutert werden. In einem Festlegungsschritt für die Zähldaten DTM_ZD wird ein Startwert für die Zähldaten festgelegt. Diese Zähldaten werden in einem Ausgabeschritt für Zähldaten ZD_OT bei Bedarf dem Verfahren zum Ausführen eines Applikationsprogramms (linke Seite) über einen Eingabeschritt für Zähldaten ZD_IN zur Verfügung gestellt.

Der eigentliche Testlauf besteht aus sich wiederholenden Prozeduren, die für alle Applikationsdatensätze durchgeführt wird, die in der Speichereinheit gespeichert sind (in Figur 5 auf der rechten Seite dargestellt). Für jeden Applikationsdatensatz mit den aktuellen Zählelementen der Zähldaten wird Folgendes durchgeführt:

In einem Decodierungsschritt für den Applikationsdatensatz DEC_ADS wird der Applikationsdatensatz decodiert. In einem Prüfschritt für die Zähldaten TST_ZD wird geprüft, ob das Zählelement dem aktuell in Prüfung befindlichen Prüflauf oder dem letzten Prüflauf entspricht. In einem Prüflauf für die Diversitätskenndaten TST_DD wird geprüft, ob der Applikationsdatensatz Diversitätskenndaten aufweist, die dem zur Verfügung stehenden Vorrat VT von Diversitätskenndaten (vgl. Figuren 3 und 4) entspricht. In einem Prüfschritt für die Redundanzdaten TST_RD wird geprüft, ob die Redundanzdaten einen erwarteten Wert, insbesondere einen Vorbelegungswert, aufweisen (optional).

Sind alle Prüfschritte durchgeführt worden, wird in einem Abfrageschritt für Abweichungen DVG? geprüft, ob einer der Prüfschritte, wie vorstehend beschrieben, Abweichungen von dem erwarteten Ergebnis hervorgebracht hat. Ist dies der Fall, wird ein Fehler in einem Ausgabeschritt für Fehler ER_OT ausgegeben (hierzu im Folgenden mehr). Ist dies nicht der Fall, wird in einem Codierungsschritt für den Applikationsdatensatz COD_ADS der geprüfte Applikationsdatensatz wieder codiert, wobei dieser immer in den Zähldaten mit dem Zählelement des aktuellen Prüflaufs codiert wird. Ist der Prüflauf für alle Applikationsdatensätze durchgeführt, weisen diese somit das aktuelle Zählelement in den Zähldaten auf, und die Zähldaten können in einem Aktualisierungsschritt für die Zähldaten UPD_ZD für das ablaufende Dienstprogramm dahingehend aktualisiert werden, dass diese nun das Zählelement desjenigen Prüflaufs beinhalten, der anschließend begonnen wird.

Bei dem Verfahren zum rechnergestützten Ausführen eines Applikationsprogramms (linke Seite in Figur 5) wird nach dem bereits erwähnten Eingabeschritt für die Zähldaten ZD_IN wiederholt für alle erforderlichen Applikationsdatensätze der durch das Applikationsprogramm durchgeführten Applikation der Decodierungsschritt für den betreffenden Applikationsdatensatz DEC_ADS durchgeführt. Anschließend wird, wie bereits für den Prüflauf beschrieben, ein Prüfschritt für die Zähldaten TST_ZD, ein Prüfschritt für die Diversitätskenndaten TSD_DD und ein Prüfschritt für die Redundanzdaten TSD_RD (optional) durchgeführt.

Die Besonderheit ist, dass die Applikation auf einer nicht dargestellten Recheninstanz mit einer bestimmten Diversität durchgeführt wird, sodass die in dem Prüfschritt für die Diversitätskenndaten TSD_DT geprüften Diversitätskenndaten genau der Diversität der Recheninstanz entsprechen müssen, auf der das Applikationsprogramm durchgeführt werden soll.

Auch beim Ausführen des Applikationsprogramms wird für jeden erforderlichen Applikationsdatensatz in dem Prüfschritt für Abweichungen DVG? geprüft, ob die Prüfschritte TST... Abweichungen von den erwarteten Inhalten der Applikationsdatensätze identifiziert haben. Ist dies der Fall, wird, wie bereits erklärt, in dem Ausgabeschritt für Fehler ERR_OT ein Fehler ausgegeben. Ansonsten wird die Prüfung der Applikationsdatensätze fortgeführt, bis alle für das Applikationsprogramm erforderlichen Applikationsdatensätze geprüft wurden. Nur unter dieser Voraussetzung wird in einem Ausführungsschritt für das Applikationsprogramm RUN_APP das Applikationsprogramm ausgeführt.

Die Prüfung der Applikationsdatensätze kann bevorzugt für das Applikationsprogramm schrittweise erfolgen (in Figur 5 nicht näher dargestellt). D. h., dass die Abarbeitung des Applikationsprogramms in Schritte der Abarbeitung unterteilt ist. In dem Sinne sind alle für das Applikationsprogramm erforderlichen Applikationsdatensätze zu prüfen, die jeweils für den nächsten durch das Applikationsprogramm durchzuführenden Schritt erforderlich sind. In dem Ausführungsschritt für das Applikationsprogramm RUN_APP wird dann jeweils der betreffende Schritt des Applikationsprogramms ausgeführt. Für jedes Applikationsprogramm ergeben sich dann in Figur 5 mehrere Rekursionsschleifen, die nach dem im Folgenden noch beschriebenen Kodierungsschritt für den Applikationsdatensatz COD_ADS (auf der linken Seite von Figur 5) wieder zu dem Eingabeschritt der Zähldaten führt.

Nach dem Ausführungsschritt für das Applikationsprogramm RUN_APP wird geprüft, ob es sich bei den nach der Ausführung des Applikationsprogramms bestehenden Applikationsdatensätzen um neue Applikationsdatensätze handelt. Diese Prüfung (Abfrageschritt neuer Applikationsdatensatz NW_ADS? genannt) ist erforderlich, damit neuen Applikationsdatensätzen in einem Festlegungsschritt für einen Prüfdatenabschnitt DTM_PA Prüfdaten zugeordnet werden, die einer anschließenden Prüfung des neuen Applikationsdatensatzes ADS in den weiteren Schritten des vorgestellten Verfahrens ermöglicht. In jedem Fall wird der neue Applikationsdatensatz bzw. auch die alten Applikationsdatensätze in dem Codierungsschritt für Applikationsdatensätze COD_ADS wieder codiert und in der Speichereinheit abgespeichert. Anschließend kann ein weiteres Applikationsprogramm oder wie oben beschrieben ein weiterer Schritt eines laufenden Applikationsprogramms durchgeführt werden (Wiederholung von ZD_IN, Eingabeschritt für Zähldaten und der nachfolgenden Schritte).

Es können auch mehrere Applikationsprogramme in redundanten Recheninstanzen gleichzeitig abgearbeitet werden. In diesem Fall würde in nicht dargestellter Weise der Ablauf zum Durchführen von Applikationsprogrammen mehrfach nebeneinander parallel dargestellt sein.

Der Durchführungsschritt für das Applikationsprogramm RUN_APP kann auch Ergebnisse erzielen, welche ausgegeben werden sollen. Bevor dies geschieht, kann optional, dargestellt in der Mitte von Figur 5, ebenfalls eine Testprozedur durchlaufen werden. Hierbei werden die bereits erläuterten Schritte, also der Prüfschritt für die Zähldaten TSD_ZD, der Prüfschritt für die Diversitätskenndaten TSD_DD sowie (optional) der Prüfschritt für die Redundanzdaten TSD_RD durchgeführt. In einem nachfolgenden Abfrageschritt für Abweichungen DVG? wird wieder geprüft, ob bei den Prüfschritten Abweichungen festgestellt werden konnten. Wenn dies der Fall ist, wird, wie bereits beschrieben, in einem Ausgabeschritt für einen Fehler ERR_OT ein Fehlersignal erzeugt. Andernfalls wird in einem Ausgabeschritt für das Ergebnis OT_RS das Ergebnis ausgegeben und/oder in weiteren Schritten weiterverarbeitet.

Für den Fall, dass in einem Ausgabeschritt für einen Fehler ERR_OT ein Fehler ausgegeben wird, wird in dem Ausführungsbeispiel gemäß Figur 5 das Verfahren sofort gestoppt. Anschließend kann die Rechenumgebung durch den Initialisierungsschritt INI zurückgesetzt werden und das Verfahren beispielsweise wieder gestartet werden.

Bezugszeichenliste

| | |
|---|---|
| LZ | Leitzentrale |
| STW | Stellwerk |
| RZ | Rechenzentrum |
| GL | Gleis |
| WH | Weiche |
| WA | Weichenantrieb |
| LS | Lichtsignal |
| CL | Controller für Lichtsignal |
| BL | Balise |

| | |
|---|---|
| RU | Rechenumgebung |
| HR1 ... HR3 | Hostrechner |
| SE1 ... SE3 | Speichereinheit |
| S1 ... S14 | Schnittstelle |
| CLD | Cloud |
| RP1 ... RP8, RPn | redundante Recheninstanz |
| AP1 ... AP5 | Applikationsprogramm |
| PK1 ... PK4 | Programmkomplex |
| KD1 ... KD13 | Konfigurationsdaten |
| MB | Message Broker |
| TG | Taktgeber |

| VT | Voter |
|---|---|
| GW | Gateway |
| KN | Knoten |

| DD1 ... DD4 | Diversitätskenndaten |
|---|---|
| ZD | Zähldaten |
| RD | Redundanzdaten |
| AD | Applikationsdaten |
| DA | Datenabschnitt mit Applikationsdaten |
| PA | Prüfdatenabschnitt |
| ADS | Applikationsdatensatz |
| CDS | codierter Applikationsdatensatz |
| GR | Gruppe |
| VR | Vorrat |
| COD | Codieren |
| DEC | Decodieren |
| RE | Lesen |
| WT | Schreiben |

| DTM_ZD | Festlegungsschritt für Zähldaten |
|---|---|
| UPD_ZD | Aktualisierungsschritt für Zähldaten |
| DEC_ADS | Decodierungsschritt für Applikationsdatensatz |
| COD_ADS | Codierungsschritt für Applikationsdatensatz |
| TST_ZD | Prüfschritt für Zähldaten |
| TST_DD | Prüfschritt für Diversitätskenndaten |
| TST_RD | Prüfschritt für Redundanzdaten |
| DVG? | Abfrageschritt für Abweichungen |
| ERR_OT | Ausgabeschritt für Fehler |
| INI | Initialisierungsschritt |
| RUN_APP | Ausführungsschritt Applikationsprogramm |
| ZD_IN | Eingabeschritt für Zähldaten |
| ZD_OT | Ausgabeschritt für Zähldaten |
| OT_RS | Ausgabeschritt für Ergebnis |
| NW_ADS? | Abfrageschritt neuer Applikationsdatensatz |
| DTM_PA | Festlegungsschritt |

**Patentansprüche**

1.  Verfahren zum rechnergestützten Betreiben einer Speichereinheit, bei dem

    • Daten in der Speichereinheit abgelegt werden und vor dem Ablegen die Daten codiert werden,
    • Daten aus der Speichereinheit abgerufen werden und nach dem Abrufen die Daten decodiert werden,

    wobei die Speichereinheit auf Fehler überwacht wird, indem eine zeitliche Abfolge von rechnergestützten Prüfläufen für die Speichereinheit durchgeführt wird,
    **dadurch gekennzeichnet,**
    **dass** zum erstmaligen Codieren (COD) der Daten

    • mindestens ein Applikationsdatensatz (ADS), enthaltend Datenabschnitte mit Applikationsdaten für ein Applikationsprogramm (AP1 ... AP5) und Prüfdatenabschnitte (PA) erzeugt oder ausgewählt wird,
    • für jeden Applikationsdatensatz (ADS) der Prüfdatenabschnitt (PA) mit Zähldaten (ZD), die den sich in der Durchführung befindenden Prüflauf kennzeichnen, belegt werden,
    • jeder Applikationsdatensatz (ADS) codiert und abgelegt wird, und dass zum Prüfen der Daten in dem sich in der Durchführung befindenden Prüflauf nach dem Abrufen und Decodieren (DEC) der Applikationsdatensätze (ADS) jeweils
    • für einen Applikationsdatensatz (ADS) ein Fehler festgestellt wird, wenn die Zähldaten (ZD) weder den sich in der Durchführung befindenden Prüflauf noch den jüngsten vollständig durchgeführten Prüflauf kennzeichnen,

- der Prüfdatenabschnitt (PA) des betreffenden Applikationsdatenabschnitts mit Zähldaten (ZD), die den sich in der Durchführung befindenden Prüflauf kennzeichnen, belegt werden, wenn kein Fehler festgestellt wurde,
- der betreffende Applikationsdatensatz (ADS) wieder codiert und abgelegt wird, wenn kein Fehler festgestellt wurde.

2. Verfahren nach Anspruch 1,
**dadurch gekennzeichnet,**
**dass** vor dem erstmaligen Durchführen eines Prüflaufes ein Startwert für die Zähldaten (ZD) festgelegt wird.

3. Verfahren nach einem der voranstehenden Ansprüche,
**dadurch gekennzeichnet,**
**dass** die Prüfläufe jeweils zumindest die Prüfung aller zu Beginn des Prüflaufes für das laufende Verfahren zur Verfügung stehenden Applikationsdatensätze beinhalten.

4. Verfahren nach einem der voranstehenden Ansprüche,
**dadurch gekennzeichnet,**
**dass**, sobald ein Prüflauf abgeschlossen wurde, die Zähldaten (ZD) mit einem Zählelement belegt werden, dass dem Zählelement für die bisherige Belegung der Zähldaten (ZD) folgt.

5. Verfahren zum rechnergestützten Ausführen eines Applikationsprogramms (AP1 ... AP5), bei dem eine Speichereinheit nach einem der voranstehenden Ansprüche betrieben wird und bei dem für das Ausführen benötigte Applikationsdatensätze aus der Speichereinheit abgerufen und decodiert werden, wobei

- nach dem Decodieren (DEC) der Applikationsdatensätze das Applikationsprogramm (AP1 ... AP5) ausgeführt wird,
- zumindest Applikationsdatensätze, die durch das Ausführen des Applikationsprogramms (AP1 ... AP5) geänderte oder erzeugte Datenabschnitte beinhalten, codiert und in der Speichereinheit abgelegt werden.

6. Verfahren nach Anspruch 5,
**dadurch gekennzeichnet,**
**dass** beim Prüfen der Daten nach dem Decodieren (DEC) der Applikationsdatensätze und vor dem Ausführen des Applikationsprogramms (AP1 ... AP5) jeweils

- für einen Applikationsdatensatz (ADS) ein Fehler festgestellt wird, wenn die Zähldaten (ZD), weder den sich in der Durchführung befindenden Prüflauf noch den jüngsten vollständig durchgeführten Prüflauf kennzeichnen,
- das Applikationsprogramm (AP1 ... AP5) ausgeführt wird, wenn kein Fehler festgestellt wurde.

7. Verfahren nach einem der voranstehenden Ansprüche,
**dadurch gekennzeichnet,**
**dass** beim rechnergestützten Betreiben der Speichereinheit zum erstmaligen Codieren (COD) der Daten zusätzlich

- mindestens eine Gruppe (GR) von Applikationsdatensätzen (ADS), enthaltend Datenabschnitte mit identischen Applikationsdaten (AD) für ein Applikationsprogramm (AP1 ... AP5) und Prüfdatenabschnitte (PA) zusätzlich mit jeweils unterschiedlichen Diversitätskenndaten (DD1 ... DD4) aus einem Vorrat (VR) möglicher Diversitätskenndaten (DD1 ... DD4) erzeugt oder ausgewählt wird,
- jeder Applikationsdatensatz (ADS) codiert und abgelegt wird, und das Abrufen der Daten erfolgt, indem die Applikationsdatensätze (ADS) abgerufen und decodiert werden, sowie das Ablegen der Daten erfolgt, indem die Applikationsdatensätze (ADS) codiert und abgelegt werden, und/oder

**dass** beim rechnergestützten Ausführen das Applikationsprogramm (AP1 ... AP5) mehrfach in redundanten Recheninstanzen (RP1 ... RPn) ausgeführt wird, wobei zum Ausführen benötigter Applikationsdatensätze (ADS) jeder Applikationsdatensatz (ADS) einer codierten Gruppe (GR) von Applikationsdatensätzen (ADS) aus der Speichereinheit abgerufen und decodiert wird, wobei

- zum Prüfen der Daten nach dem Decodieren (DEC) der Applikationsdatensätze (ADS) jeweils für einen Applikationsdatensatz (ADS) ein Fehler festgestellt wird, wenn die Diversitätskenndaten (DD1 ... DD4) in dem Applikationsdatensatz (ADS) von allen möglichen Diversitätskenndaten (DD1 ... DD4) dieser Recheninstanz (RP1, RP2, RPn) aus dem Vorrat (VR) abweichen,
- das Applikationsprogramm (AP1 ... AP5) mit den Datenabschnitten jedes Applikationsdatensatzes (ADS) der betreffenden Gruppe (GR) ausgeführt wird, wenn kein Fehler festgestellt wurde, und/oder
- zumindest Applikationsdatensätze (ADS), die durch das Ausführen des Applikationsprogramms (AP1 ... AP5) geänderte oder erzeugte Datenabschnitte beinhalten, nach in der oben genannten Weise codiert und in der Speichereinheit abgelegt werden.

8. Verfahren nach einem der voranstehenden Ansprüche,
**dadurch gekennzeichnet,**
**dass** vor dem Codieren (COD) der Prüfdatenabschnitt (PA) derart erstellt wird, dass dieser zusätzlich redundanten Speicherplatz mit vorgegebenen Redundanzdaten (RD) aufweist.

9. Verfahren nach einem der voranstehenden Ansprüche,
**dadurch gekennzeichnet,**
**dass** die Applikationsdatenabschnitte aus Datenwörtern bestehen.

10. Verfahren nach einem der voranstehenden Ansprüche,
**dadurch gekennzeichnet,**
**dass** das Verfahren unter gleichzeitiger Nutzung von mindestens zwei Prozessoren oder Prozessorkernen durchgeführt wird.

11. Verfahren nach Anspruch 10,
**dadurch gekennzeichnet,**
**dass** die mindestens zwei Prozessoren oder Prozessorkerne gemeinsam auf ein und dieselbe Speichereinheit (SE1 ... SE3) zugreifen.

12. Verfahren nach einem der voranstehenden Ansprüche,
**dadurch gekennzeichnet,**
**dass**

- mit mehrfach gespeicherten identischen Datenabschnitten und/oder mit mehrfach identisch geänderten Datenabschnitten ein Voting durchgeführt wird,
- wenn aufgrund des Votings ein Fehler identifiziert wird, Applikationsdatensätze (ADS), die für die Fehleridentifizierung ursächliche Datenabschnitte enthalten, von einer weiteren Bearbeitung ausgeschlossen werden.

13. Verfahren nach einem der voranstehenden Ansprüche,
**dadurch gekennzeichnet,**
**dass**

- Applikationsdatensätze (ADS), die für Fehler ursächliche Datenabschnitte enthalten, unter Nutzung der fehlerfreien Datenabschnitte der entsprechender Applikationsdatensätze (ADS) aktualisiert werden,
- die aktualisierten Applikationsdatensätze (ADS) wieder in die weitere Bearbeitung einbezogen werden.

14. Computerprogrammprodukt mit Programmbefehlen zur Durchführung des Verfahrens nach einem der voranstehenden Ansprüche.

15. Bereitstellungsvorrichtung für das Computerprogrammprodukt nach Anspruch 14, wobei die Bereitstellungsvorrichtung das Computerprogrammprodukt speichert und/oder bereitstellt.

**Claims**

1. Method for computer-assisted operation of a memory unit, wherein

- data is saved in the memory unit and the data is encoded before saving,
- data is retrieved from the memory unit and the data is decoded after retrieval,

wherein the memory unit is monitored for errors in that a temporal sequence of computer-assisted checking operations is carried out for the memory unit,
**characterised in that**
for first-time encoding (COD) of the data

• at least one application data set (ADS) is generated or selected, containing data segments having application data for an application program (AP1 ... AP5) and check data segments (PA),
• for each application data set (ADS), the check data segment (PA) is occupied by count data (ZD), which characterises the checking operation being implemented,
• each application data set (ADS) is encoded and saved, and that for checking the data in the checking operation being implemented, after retrieving and decoding (DEC) the application data sets (ADS) respectively
• an error is determined for an application data set (ADS) when the count data (ZD) characterises neither the checking operation being implemented nor the most recent completely implemented checking operation,
• the check data segment (PA) of the relevant application data set is occupied by count data (ZD), which characterises the checking operation being implemented, if no error was determined,
• the relevant application data set (ADS) is encoded and saved again if no error was determined.

2. Method according to claim 1,
**characterised in that**
a start value is defined for the count data (ZD) before first-time implementation of a checking operation.

3. Method according to one of the preceding claims, **characterised in that**
the checking operations respectively include at least the checking of all application data sets available at the beginning of the checking operation for the ongoing method.

4. Method according to one of the preceding claims, **characterised in that**
as soon as a checking operation has been completed, the count data (ZD) is occupied by a count element, which follows the count element for the previous occupation of the count data (ZD) .

5. Method for computer-assisted execution of an application program (AP1 ... AP5), wherein a memory unit is operated according to one of the preceding claims and wherein application data sets required for the execution are retrieved from the memory unit and decoded, wherein

• after decoding (DEC) of the application data sets the application program (AP1 ... AP5) is executed,
• at least application data sets, which include data segments changed or generated by the execution of the application program (AP1 ... AP5), are encoded and saved in the memory unit.

6. Method according to claim 5,
**characterised in that**
when checking the data after decoding (DEC) of the application data sets and before execution of the application program (AP1 ... AP5) respectively

• an error is determined for an application data set (ADS) when the count data (ZD) characterises neither the checking operation being implemented nor the most recent completely implemented checking operation,
• the application program (AP1 ... AP5) is executed if no error has been determined.

7. Method according to one of the preceding claims, **characterised in that**
additionally, during the computer-assisted operation of the memory unit, for first-time encoding (COD) of the data,

• at least one group (GR) of application data sets (ADS), containing data segments having identical application data (AD) for an application program (AP1 ... AP5) and check data segments (PA) having different diversity characteristic data (DD1 ... DD4) respectively is generated or selected from a supply (VR) of possible diversity characteristic data (DD1 ... DD4),
• each application data set (ADS) is encoded and saved, and the data is retrieved **in that** the application data sets (ADS) are retrieved and decoded, and the data is saved **in that** the application data sets (ADS) are encoded and saved,
and/or
during the computer-assisted execution, the application program (AP1 ... AP5) is executed multiple times in redundant computing instances (RP1 ... RPn), wherein in order to execute required application data sets (ADS), each application data set (ADS) of an encoded group (GR) of application data sets (ADS) is retrieved from the memory unit and decoded, wherein

• in order to check the data after the decoding (DEC) of the application data sets (ADS), an error is determined respectively for an application data set (ADS) if the diversity characteristic data (DD1 ... DD4) in the application data set (ADS) deviates from all possible diversity characteristic data (DD1 ... DD4) of said computing instance (RP1, RP2, RPn) from the supply (VR),

• the application program (AP1 ... AP5) with the data segments of each application data set (ADS) of the relevant group (GR) is executed if no error was determined,

and/or

• at least application data sets (ADS), which include data segments changed or generated by the execution of the application program (AP1 ... AP5), are encoded according to the manner mentioned above and saved in the memory unit.

8. Method according to one of the preceding claims, **characterised in that**
before encoding (COD), the check data segment (PA) is created in such a way that it also has redundant memory space with predefined redundancy data (RD).

9. Method according to one of the preceding claims, **characterised in that**
the application data segments consist of data words.

10. Method according to one of the preceding claims, **characterised in that**
the method is carried out with simultaneous use of at least two processors or processing cores.

11. Method according to claim 10,
**characterised in that**
the at least two processors or processing cores have shared access to one and the same memory unit (SE1 ... SE3).

12. Method according to one of the preceding claims, **characterised in that**

• with multiply stored identical data segments and/or with multiply identical changed data segments, voting is carried out,

• if, owing to the voting, an error is identified, application data sets (ADS), which contain data segments causative of the error identification, are excluded from further processing.

13. Method according to one of the preceding claims, **characterised in that**

• application data sets (ADS), which contain data segments causative of errors, are updated using the error-free data segments of the corresponding application data sets (ADS),

• the updated application data sets (ADS) are again incorporated in further processing.

14. Computer program product having program commands for carrying out the method according to one of the preceding claims.

15. Provision apparatus for the computer program product according to claim 14, wherein the provision apparatus saves and/or provides the computer program product.


**Revendications**

1. Procédé pour faire fonctionner une unité de mémoire avec l'assistance d'un ordinateur, dans lequel

• on met des données dans l'unité de mémoire et, avant de les mettre, on code les données,
• on appelle des données de l'unité de mémoire et on décode les données après les avoir appelées,

dans lequel on contrôle, s'il y a une erreur dans l'unité de mémoire, en effectuant une séquence temporelle de passes de contrôle assistées par ordinateur de l'unité de mémoire, **caractérisé en ce que**
pour le codage (COD) pour la première fois des données

• on produit ou on sélectionne au moins un ensemble (ADS) de données d'application, contenant des parties de données ayant des données d'application pour un programme (AP1 ... AP5) d'application et des parties (PA) de données de contrôle,

• pour chaque ensemble (ADS) de données d'application, on impose, à la partie (PA) de données de contrôle, des données (ZD) de compte, qui caractérisent la passe de contrôle se trouvant en exécution,

• on code et on met en mémoire chaque ensemble (ADS) de données d'application et **en ce que**, pour le contrôle des données dans la passe de contrôle se trouvant en exécution, après avoir appelé et décodé (DEC) les ensembles (ADS) de données d'application respectivement

• pour un ensemble (ADS) de données d'application, on constate une erreur, si les données (ZD) de compte ne caractérisent ni la passe de contrôle se trouvant en exécution, ni la passe de contrôle la plus récente exécutée complètement,

• on impose, à la partie (PA) de données de contrôle de la partie de données d'application concernée, des données (ZD) de compte, qui caractérisent la passe de contrôle se trouvant en exécution, si l'on n'a pas constaté d'erreur,

• on code et on met en mémoire à nouveau l'ensemble (ADS) de données d'application concerné, si l'on n'a pas constaté d'erreur.

2. Procédé suivant la revendication 1,
**caractérisé**
**en ce que**, avant l'exécution pour la première fois d'une passe de contrôle, on fixe une valeur de début pour les données (ZD) de compte.

3. Procédé suivant l'une des revendications précédentes, **caractérisé**
**en ce que** les passes de contrôle contiennent chacune au moins le contrôle de tous les ensembles de données d'application disponibles au début de la passe de contrôle pour le procédé en cours.

4. Procédé suivant l'une des revendications précédentes, **caractérisé**
**en ce que**, dès qu'une passe de contrôle a été terminée, on impose aux données (ZD) de compte un élément de compte, en ce que l'élément de compte fait suite à l'imposition jusqu'ici des données (ZD) de compte.

5. Procédé d'exécution assisté par ordinateur d'un programme (AP1 ... AP5) d'application, dans lequel on fait fonctionner une unité de mémoire suivant l'une des revendications précédentes et dans lequel on appelle, de l'unité de mémoire, des ensembles de données d'application nécessaires à l'exécution et on les décode, dans lequel

• après le décodage (DEC) des ensembles de données d'application, on exécute le programme (AP1 ... AP5) d'application,

• on code au moins des ensembles de données d'application, qui contiennent des parties de données produites ou modifiées par l'exécution du programme (AP1 ... AP5) d'application et on les met dans l'unité de mémoire.

6. Procédé suivant la revendication 5,
**caractérisé**
**en ce que**, lors du contrôle des données, après le décodage (DEC) des ensembles de données d'application et avant l'exécution du programme (AP1 ... AP5) d'application respectivement

• on constate, pour un ensemble (ADS) de données d'application, une erreur, si les données (ZD) de compte ne caractérisent ni la passe de contrôle se trouvant en exécution, ni la passe de contrôle la plus récente effectuée complètement,

• on exécute le programme (AP1 ... AP5) d'application, s'il n'a pas été constaté d'erreur.

7. Procédé suivant l'une des revendications précédentes, **caractérisé**
**en ce que**, lors du fonctionnement assisté par ordinateur de l'unité de mémoire, pour le codage (COD) pour la première fois des données en outre

• on produit ou on sélectionne au moins un groupe (GR) d'ensembles (ADS) de données d'application, contenant des parties de données ayant des données (AD) d'application identiques pour un programme (AP1 ... AP5) d'application et des parties (PA) de données de contrôle, supplémentairement à respectivement des données (DD1 ... DD4) caractéristiques de diversité différentes provenant d'une réserve (VR) de données (DD1 ... DD4) caractéristiques de diversité possibles,

- on code et on met en mémoire chaque ensemble (ADS) de données d'application

et on effectue l'appel des données, en appelant et en décodant les ensembles (ADS) de données d'application ainsi que l'on fait suivre de la mise en mémoire des données, en codant et en mettant en mémoire les ensembles (ADS) de données d'application,
et/ou
**en ce que**, lors de l'exécution assistée par ordinateur, on exécute le programme (AP1 ... AP5) d'application plusieurs fois dans des instances (RP1 ... RPn) informatiques redondantes, dans lequel, pour l'exécution d'ensembles (ADS) de données d'application nécessaires, on appelle, de l'unité de mémoire, chaque ensemble (ADS) de données d'application d'un groupe (GR) codé d'ensembles (ADS) de données d'application et on les décode, dans lequel

- pour le contrôle des données, après le décodage (DEC) des ensembles (ADS) de données d'application, on constate une erreur pour un ensemble (ADS) de données d'application, si les données (DD1 ... DD4) caractéristiques de diversité dans l'ensemble (ADS) de données d'application s'écarte de toutes les données (DD1 ... DD4) caractéristiques de diversité possibles de cette instance (RP1, RP2, RPn) informatique de la réserve (VR),
- on exécute le programme (AP1 ... AP5) d'application avec les parties de données de chaque ensemble (ADS) de données d'application du groupe (GR) concerné, s'il n'a pas été constaté d'erreur,
et/ou
- on code, de la façon mentionnée ci-dessus, au moins des ensembles (ADS) de données d'application, qui contiennent des parties de données produites ou modifiées par l'exécution du programme (AP1 ... AP5) d'application et on les met dans l'unité de mémoire.

8. Procédé suivant l'une des revendications précédentes, **caractérisé en ce que**, avant le codage (COD), on crée la partie (PA) de données de contrôle, de façon à ce que celle-ci ait supplémentairement un emplacement de mémoire redondant ayant des données (RD) de redondance données à l'avance.

9. Procédé suivant l'une des revendications précédentes, **caractérisé en ce que** les parties de données d'application sont constituées de mots de données.

10. Procédé suivant l'une des revendications précédentes, **caractérisé en ce que** l'on exécute le procédé avec utilisation simultanée d'au moins deux processeurs ou noyaux de processeur.

11. Procédé suivant la revendication 10,
**caractérisé**
**en ce que** les au moins deux processeurs ou noyaux de processeur accèdent conjointement à la une et même unité (SE1 ... SE3) de mémoire.

12. Procédé suivant l'une des revendications précédentes, **caractérisé**
**en ce que**

- l'on exécute un voting par des parties de données identiques mémorisées plusieurs fois et/ou par des parties de données modifiées plusieurs fois de manière identique,
- si, sur la base du voting, on identifie une erreur, on exclue d'un autre traitement des ensembles (ADS) de données d'application, qui contiennent des parties de données à l'origine de l'identification de l'erreur.

13. Procédé suivant l'une des revendications précédentes, **caractérisé**
**en ce que**

- l'on met à jour des ensembles (ADS) de données d'application, qui contiennent des parties de données à l'origine de l'erreur, en utilisant des parties de données sans erreur des ensembles (ADS) de données d'application correspondants,
- l'on introduit à nouveau, dans le traitement ultérieur, les ensembles (ADS) de données d'application mis à jour.

14. Produit de programme d'ordinateur comprenant des instructions de programme pour exécuter le procédé suivant l'une des revendications précédentes.

**15.** Dispositif de mise à disposition du produit de programme d'ordinateur suivant la revendication 14, dans lequel le dispositif de mise à disposition met en mémoire et/ou met en disposition le produit de programme d'ordinateur.

## FIG 1

FIG 2A

FIG 2

| FIG 2A |
| FIG 2B |

FIG 2B

EP 4 266 175 B1

# FIG 3

# FIG 4

# FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 201400924382 A

- DE 102007040721